# EUROPEAN PATENT APPLICATION

(11) **EP 4 722 223 A1**
(43) Date of publication of application: **08.04.2026**
(21) Application number: 24822364.6
(22) Date of filing: 09.04.2024
(51) Int. Cl.: C07F 9/54, H10K 30/88, H10K 30/50

(54) **PHOSPHORUS-CONTAINING PASSIVATOR, PEROVSKITE SOLAR CELL, PHOTOVOLTAIC MODULE, PHOTOVOLTAIC SYSTEM AND ELECTRICAL APPARATUS**

(30) Priority: 14.06.2023 CN 202310708422
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: JIA, Boyu, Shanghai 200241 (CN); LIANG, Weifeng, Shanghai 200241 (CN); GU, Shuai, Shanghai 200241 (CN); SHI, Ruoxuan, Shanghai 200241 (CN); CHEN, Guodong, Shanghai 200241 (CN); GUO, Yongsheng, Shanghai 200241 (CN)
(74) Representative: Gong, Jinping
(86) International application number: PCT/CN2024/086861
(87) International publication number: WO 2024/255409

(57) **Abstract**

A phosphorus-containing passivator, a perovskite solar cell, a photovoltaic module, a photovoltaic system, and an electric apparatus are provided. The phosphorus-containing passivator includes an ionic compound, the ionic compound includes a cationic group, and the cationic group has a structure represented by formula (I): A-L-B (I); where A represents an organophosphorus group with lone pair electrons, B represents a positively charged organophosphorus salt group, and L represents a linking group between the organophosphorus group and the organophosphorus salt group. The lone pair electrons of the organophosphorus group can form strong P-Pb coordination bonds with under-coordinated lead ions in the bulk phase and/or at the upper and lower interfaces of a perovskite light-absorbing layer, passivating low-coordinated lead ion defects; the organophosphorus salt group can form low-dimensional perovskite at the upper and lower interfaces of a perovskite layer, passivating the interfaces of the perovskite layer and suppressing ion migration; and through the synergistic effect of the organophosphorus group and the organophosphorus salt group, the optoelectronic performance and stability of perovskite solar cells can be improved.

## Description

The present application refers to Chinese Patent Application No. 202310708422.3, filed on June 14, 2023, entitled " PHOSPHORUS-CONTAINING PASSIVATOR, PEROVSKITE SOLAR CELL, PHOTOVOLTAIC MODULE, PHOTOVOLTAIC SYSTEM, AND ELECTRIC APPARATUS", which is incorporated herein by reference in its entirety.

### TECHNICAL FIELD

The present application relates to the field of solar cell technologies, and more particularly to a phosphorus-containing passivator, a perovskite solar cell, a photovoltaic module, a photovoltaic system, and an electric apparatus.

### BACKGROUND

Perovskite solar cells belong to the third-generation solar cells, exhibit excellent optoelectronic properties, high light absorption coefficients, long carrier lifetimes, and extended diffusion lengths, and have become outstanding among third-generation novel solar cells.

However, during the preparation of perovskite solar cells as thin films, numerous defects are present in the bulk phase and on the surface, including deep-level traps such as under-coordinated Pb²⁺, Pb clusters, under-coordinated halide ions, and anti-site defects PbI₃⁻ caused by ion migration, as well as shallow-level defects such as halide X⁻ vacancies and A-site cation vacancies. The presence of these defects affects the optoelectronic performance and stability of perovskite solar cells.

### SUMMARY

The present application is made in view of the above issues, with the objective of providing a phosphorus-containing passivator, a perovskite solar cell, a photovoltaic module, a photovoltaic system, and an electric apparatus, so as to improve the optoelectronic performance and stability of perovskite solar cells.

The present application is achieved through the following technical solutions.

A first aspect of the present application provides a phosphorus-containing passivator, where the phosphorus-containing passivator includes an ionic compound, the ionic compound includes a cationic group, and the cationic group has a structure represented by formula (I) below:

A-L-B (I)

where A represents an organophosphorus group with lone pair electrons, B represents a positively charged organophosphorus salt group, and L represents a linking group between the organophosphorus group and the organophosphorus salt group.

The phosphorus-containing passivator of the present application includes the organophosphorus group with lone pair electrons and the positively charged organophosphorus salt group. The lone pair electrons of the organophosphorus group can form strong P-Pb coordination bonds with under-coordinated lead ions in the bulk phase and/or at the upper and lower interfaces of a perovskite light-absorbing layer, passivating low-coordinated lead ion defects; and the organophosphorus salt group can form low-dimensional perovskite at the upper and lower interfaces of a perovskite layer, passivating the interfaces of the perovskite layer and suppressing ion migration. Thus, through the synergistic effect of the organophosphorus group and the organophosphorus salt group, the optoelectronic performance and stability of perovskite solar cells can be improved.

In some embodiments, the ionic compound further includes an anionic group, where the anionic group includes one or more of halide anions, pseudo halide anions, tetrafluoroborate ions, hexafluorophosphate ions, and bis(methanesulfonyl)amide ions. The halide anions and the halogen-containing anionic groups can respectively passivate iodide ion vacancies, reducing energy loss.

In some embodiments, L includes one or more of substituted or unsubstituted alkylene, substituted or unsubstituted cycloalkylene, and substituted or unsubstituted aryl and arylene.

In some embodiments, the phosphorus-containing passivator has a structure represented by formula (II) below: 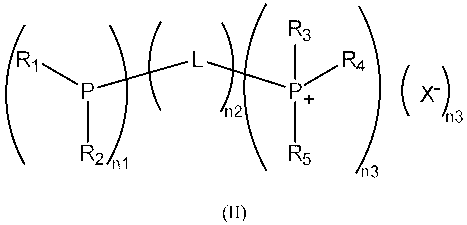
where R₁, R₂, R₃, R₄, and R₅ each include any one of substituted or unsubstituted alkyl, substituted or unsubstituted cycloalkyl, and substituted or unsubstituted aryl;
L includes any one of substituted or unsubstituted alkylene, substituted or unsubstituted cycloalkylene, and substituted or unsubstituted aryl and arylene;
X includes any one of halide anions and halogen-containing anionic groups; and
1 ≤ n1 ≤ 4, 1 ≤ n2 ≤ 10, 1 ≤ n3 ≤ 4, and n1, n2, n3 are integers.

In some embodiments, R₁, R₂, R₃, R₄, and R₅ each include any one of alkyl having 1-10 carbon atoms, cycloalkyl having 1-10 carbon atoms, phenyl, and substituted phenyl; and substituents in the substituted phenyl include one or more of halogen, alkyl, cycloalkyl, alkoxy, alkylthio, alkylsilyl, and alkoxysilyl; and
optionally, the substituents in the substituted phenyl include one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

In some embodiments, R₁ and R₂ each include any one of cycloalkyl having 1-10 carbon atoms and phenyl; and
optionally, R₁ and R₂ each identically include any one of cycloalkyl having 1-10 carbon atoms and phenyl.

In some embodiments, R₃, R₄, and R₅ each include any one of alkyl having 1-10 carbon atoms; and
optionally, R₃, R₄, and R₅ each identically include any one of alkyl having 1-10 carbon atoms.

In some embodiments, L includes any one of alkylene having 1-10 carbon atoms, cycloalkylene having 1-10 carbon atoms, phenylene, and substituted phenylene; and substituents in the substituted phenylene include one or more of halogen, alkyl, cycloalkyl, alkoxy, alkylthio, alkylsilyl, and alkoxysilyl; and
optionally, the substituents in the substituted phenylene include one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

In some embodiments, L includes any one of alkylene having 1-10 carbon atoms.

In some embodiments, X includes any one of iodide ions and tetrafluoroborate ions.

In some embodiments, the phosphorus-containing passivator includes any one of the following structural formulas:

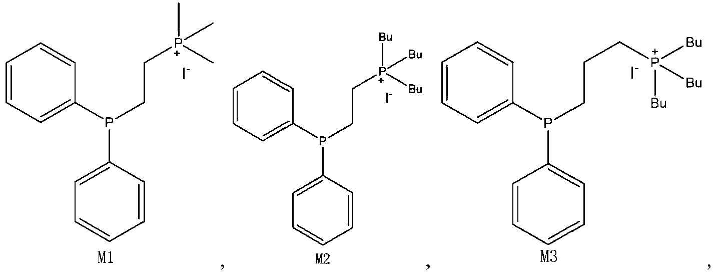

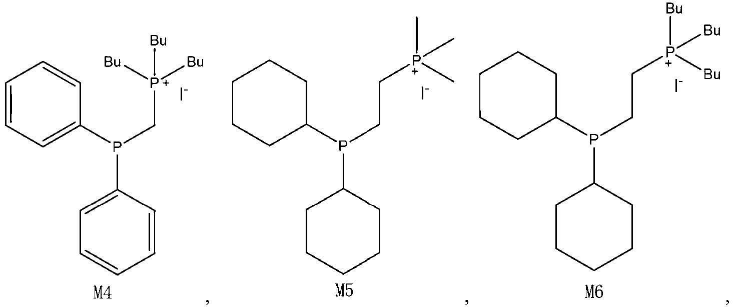

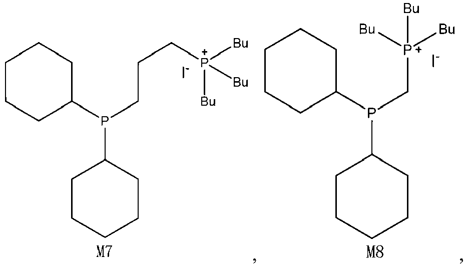

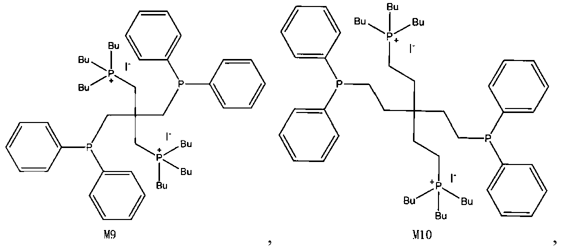

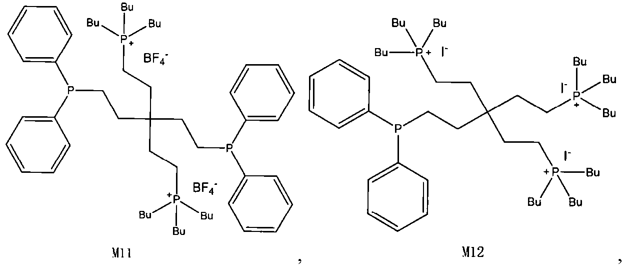

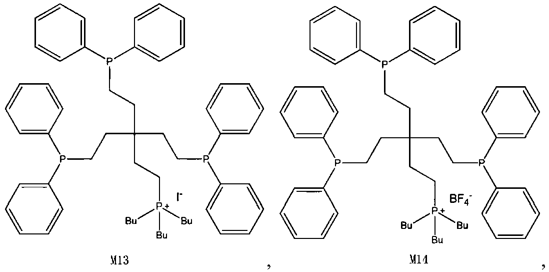

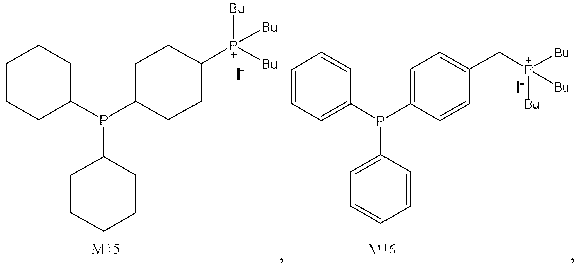

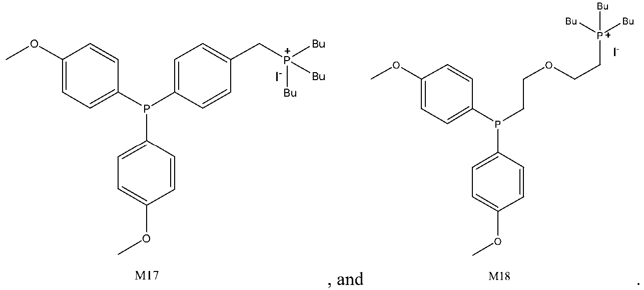

A second aspect of the present application provides a perovskite solar cell, where the perovskite solar cell includes the phosphorus-containing passivator according to the first aspect of the present application. By adding the phosphorus-containing passivator during the preparation process, a perovskite solar cell containing the phosphorus-containing passivator is obtained, where the phosphorus-containing passivator can coordinatively passivate under-coordinated lead ion defects, interface defects, and iodide ion vacancy defects, which reduces energy loss of charges in the bulk phase and/or at the interfaces of a perovskite light-absorbing layer, thereby improving the optoelectronic performance and stability of the perovskite solar cell.

In some embodiments, the perovskite solar cell includes a perovskite light-absorbing layer, where the perovskite light-absorbing layer includes the phosphorus-containing passivator. During the preparation of the perovskite light-absorbing layer, the phosphorus-containing passivator is directly added to passivate under-coordinated lead ion defects, interface defects, and iodide ion vacancy defects of the perovskite light-absorbing layer; and
optionally, a mass proportion of the phosphorus-containing passivator in the perovskite light-absorbing layer is 0.01% to 1%; and optionally, 0.05% to 0.5%. With the mass proportion of the phosphorus-containing passivator in the perovskite light-absorbing layer being within the above range, under-coordinated lead ion defects, interface defects, and iodide ion vacancy defects of the perovskite light-absorbing layer can be effectively passivated.

In some embodiments, the perovskite solar cell includes a perovskite light-absorbing layer and a passivation layer that are arranged in a stacked manner, where the passivation layer is located on a light-incident side or a light-exit side of the perovskite light-absorbing layer, and the passivation layer includes the phosphorus-containing passivator; and optionally, a thickness of the passivation layer is 0.1 nm to 10 nm; and optionally, 1 nm to 10 nm.

Forming a passivation layer on an upper surface or a lower surface of the perovskite light-absorbing layer can passivate under-coordinated lead ion defects, interface defects, and iodide ion vacancy defects of the perovskite light-absorbing layer. With the thickness of the passivation layer being within the above range, under-coordinated lead ion defects, interface defects, and iodide ion vacancy defects of the perovskite light-absorbing layer can be effectively passivated.

In some embodiments, the perovskite light-absorbing layer includes an active material with a molecular formula of ABX₃ or A₂CDX₆; and
optionally, the active material with the molecular formula of ABX3 or A₂CDX₆ has at least one of the following characteristics:
(1) A includes one or more of organic cations and inorganic cations; and optionally, A includes one or more of monovalent formamidinium cations, monovalent ammonium cations, and Cs⁺;
(2) B includes one or more of organic cations and inorganic cations; and optionally, B includes one or more of Pb²⁺ and Sn²⁺;
(3) C includes one or more of organic cations and inorganic cations; and optionally, C includes Ag⁺;
(4) D includes one or more of organic cations and inorganic cations; and optionally, D includes one or more of Bi³⁺, Sb³⁺, and In³⁺; and
(5) X includes one or more of organic anions and inorganic anions; and optionally, X includes one or more of Br⁻ and I⁻.

In some embodiments, the perovskite light-absorbing layer has at least one of the following characteristics:
(1) a thickness of the perovskite light-absorbing layer is 100 nm to 1000 nm; and
(2) a bandgap width of the perovskite light-absorbing layer is 1.2 eV to 2.3 eV.

With the thickness of the perovskite light-absorbing layer being within the above range, sunlight can be effectively absorbed, achieving optimal photoelectric conversion efficiency and stability. With the bandgap width of the perovskite light-absorbing layer being within the above range, high visible light absorption efficiency can be achieved.

In some embodiments, the perovskite solar cell further includes an electron transport layer, a barrier layer, and an electrode layer that are located on a light-exit side of the perovskite light-absorbing layer, where the electron transport layer, the barrier layer, and the electrode layer are sequentially arranged in a stacked manner, and the electron transport layer is closer to the perovskite light-absorbing layer;
optionally, a material of the barrier layer includes one or more of 2,9-dimethyl-4,7-diphenyl-1,10-phenanthroline, SnO₂, ZnO, and cerium-containing oxides; and
optionally, a thickness of the barrier layer is 0.5 nm to 20 nm.

The barrier layer can effectively block the transport of holes, reducing energy loss due to charge recombination. By using the above materials to prepare the barrier layer, the barrier layer can have a lower valence band top, further enhancing the effect of the barrier layer on the transport of holes. With the thickness of the barrier layer being within the above range, holes can be effectively blocked without being too thick to affect electron transport.

A third aspect of the present application provides a photovoltaic module including the perovskite solar cell according to the second aspect of the present application. The perovskite solar cell has high photoelectric conversion efficiency and good stability, which can improve the photoelectric efficiency and stability of the photovoltaic module.

A fourth aspect of the present application provides a photovoltaic system including the photovoltaic module according to the third aspect of the present application. The photovoltaic system utilizes the perovskite solar cell in the photovoltaic module to directly convert solar radiation energy into electrical energy, with high efficiency and good stability.

A fifth aspect of the present application provides an electric apparatus including the perovskite solar cell according to the second aspect of the present application.

### BRIEF DESCRIPTION OF DRAWINGS

To describe the technical solutions in the present application more clearly, the following briefly describes the accompanying drawings used in the present application. Apparently, the accompanying drawings in the following description show only some embodiments of the present application, and a person of ordinary skill in the art may still derive other drawings from these accompanying drawings without creative efforts.
FIG. 1 is a schematic diagram of a structure of a perovskite solar cell according to an embodiment of the present application.
FIG. 2 is a schematic diagram of a structure of a perovskite solar cell according to an embodiment of the present application.
FIG. 3 is a schematic diagram of a structure of a perovskite solar cell according to an embodiment of the present application.
FIG. 4 is a schematic diagram of an electric apparatus using a perovskite solar cell as a power source according to an embodiment of the present application.

### DESCRIPTION OF EMBODIMENTS

To facilitate the understanding of the present application, the present application will be described more comprehensively with reference to the relevant accompanying drawings. Preferred embodiments of the present application are shown in the accompanying drawings. However, the present application can be implemented in many different forms and is not limited to the embodiments described herein. Rather, these embodiments are provided for the purpose of providing a more thorough understanding of the disclosure of the present application.

Unless otherwise defined, all technical and scientific terms used herein shall have the same meanings as commonly understood by those skilled in the art to which the present application pertains. The terms used herein in the specification of the present application are for description of specific embodiments only without any intention to limit the present application.

In the present application, the technical features described in an open-ended manner include the closed technical solutions composed of the enumerated features, as well as the open technical solutions that contain the enumerated features.

For brevity, this specification specifically discloses only some numerical ranges. However, any lower limit may be combined with any upper limit to form an unspecified range, and any lower limit may be combined with another lower limit to form an unspecified range, and likewise, any upper limit may be combined with any other upper limit to form an unspecified range. In addition, each individually disclosed point or individual single numerical value may itself be a lower limit or an upper limit which can be combined with any other point or individual numerical value or combined with another lower limit or upper limit to form a range not expressly recorded.

"Ranges" disclosed in the present application are defined in the form of lower and upper limits. A given range is defined by one lower limit and one upper limit selected, where the selected lower and upper limits define boundaries of that special range. Ranges defined in this way may or may not include end values, and any combination may be used, meaning that any lower limit may be combined with any upper limit to form a range. For example, if ranges of 60-120 and 80-110 are provided for a specific parameter, it is understood that ranges of 60-110 and 80-120 can also be envisioned. In addition, if low limit values of a range are given as 1 and 2, and upper limit values of the range are given as 3, 4, and 5, the following ranges can all be envisioned: 1-3, 1-4, 1-5, 2-3, 2-4, and 2-5. In the present application, unless otherwise stated, a value range of "a-b" is a short representation of any combination of real numbers between a and b, where both a and b are real numbers. For example, a value range of "0-5" means that all real numbers in the range of "0-5" are listed herein and "0-5" is just a short representation of combinations of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

In the present application, when numerical ranges are involved, unless otherwise specified, the above numerical ranges are considered continuous and include the minimum and maximum values of the range, as well as every value between the minimum and maximum values. Furthermore, when the range refers to integers, it includes every integer between the minimum and maximum values of the range. In addition, when multiple ranges are provided to describe features or characteristics, the ranges can be combined. In other words, unless otherwise indicated, all ranges disclosed herein should be understood to include any and all sub-ranges subsumed therein.

Unless otherwise stated, all the embodiments and optional embodiments of the present application can be combined with each other to form new technical solutions.

Unless otherwise stated, all the technical features and optional technical features of the present application can be combined with each other to form new technical solutions.

Unless otherwise specified, all the steps in the present application can be performed sequentially or randomly, preferably, performed sequentially. For example, a method including steps (a) and (b) indicates that the method may include steps (a) and (b) performed in order or may include steps (b) and (a) performed in order. For example, the foregoing method may further include step (c), which indicates that step (c) may be added to the method in any ordinal position, for example, the method may include steps (a), (b), and (c), steps (a), (c), and (b), steps (c), (a), and (b), or the like.

Unless otherwise specified, "include" and "contain" mentioned in the present application are inclusive or may be exclusive. For example, the terms "include" and "contain" can mean that other unlisted components may also be included or contained, or only listed components are included or contained.

In the descriptions of this specification, it should be noted that "more than" or "less than" is inclusive of the present number and that "more" in "one or more" means two or more than two, unless otherwise specified.

In the description of this specification, unless otherwise stated, a term "or (or)" indicates inclusion. That is, a phrase "A or (or) B" means "A, B, or both A and B". More specifically, any one of the following conditions meets the condition "A or B": A is true (or present) and B is false (or not present); A is false (or not present) and B is true (or present); or both A and B are true (or present). Unless otherwise specified, terms used in the present application have common meanings generally understood by persons skilled in the art. Unless otherwise specified, numerical values of parameters mentioned in the present application may be measured by using various measurement methods commonly used in the art (for example, testing may be performed by using a method provided in the embodiments of the present application).

In the related art, during the preparation of perovskite solar cells as thin films, numerous defects are generated in the bulk phase and on the surface, and the presence of these defects affects the optoelectronic performance and stability of perovskite solar cells. Passivating defects is an urgent issue to be addressed in the preparation of perovskite solar cells.

Currently, methods to address these defects may mainly include Lewis acid, Lewis base, anion, cation passivation, and the like. Existing reported Lewis base passivators are mostly molecules or ions containing atoms such as nitrogen, sulfur, or oxygen, with limited passivation effects.

Based on the above issues, a first aspect of the present application provides a phosphorus-containing passivator, where the phosphorus-containing passivator includes an ionic compound, the ionic compound includes a cationic group, and the cationic group has a structure represented by formula (I) below:

A-L-B (I)

where A represents an organophosphorus group with lone pair electrons, B represents a positively charged organophosphorus salt group, and L represents a linking group between the organophosphorus group and the organophosphorus salt group.

It should be noted that the number of organophosphorus groups in the cationic group may be one or more, and can be set according to actual needs; and the number of organophosphorus salt groups in the cationic group may be one or more, and can be set according to actual needs. The organophosphorus salt group may carry one positive charge or may carry multiple positive charges.

The organophosphorus group and the organophosphorus salt group in the cationic group are linked through the group L.

It can be understood that the phosphorus-containing passivator includes the organophosphorus group with lone pair electrons and the positively charged organophosphorus salt group. The lone pair electrons of the organophosphorus group can form strong P-Pb coordination bonds with under-coordinated lead ions in the bulk phase and/or at the upper and lower interfaces of a perovskite light-absorbing layer, passivating low-coordinated lead ion defects; and the organophosphorus salt group can form low-dimensional perovskite at the upper and lower interfaces of a perovskite layer, passivating the interfaces of the perovskite layer and suppressing ion migration. Thus, through the synergistic effect of the organophosphorus group and the organophosphorus salt group, the optoelectronic performance and stability of perovskite solar cells can be improved.

In some embodiments, the ionic compound further includes an anionic group, where the anionic group includes one or more of halide anions, pseudo halide anions, tetrafluoroborate ions, hexafluorophosphate ions, and bis(methanesulfonyl)amide ions. The halide anions and the halogen-containing anionic groups can respectively passivate iodide ion vacancies, reducing energy loss.

It should be noted that the halide anions are anions formed by halogen elements gaining one electron. The halogen-containing anionic groups are anionic groups formed jointly by halogen elements and other elements.

The organophosphorus group, organophosphorus salt group, and halide anions and/or halogen-containing anionic groups contained in the ionic compound of the present application can coordinatively passivate under-coordinated lead ion defects, interface defects, and iodide ion vacancy defects, which reduces energy loss of charges in the bulk phase and/or at the interfaces of the perovskite light-absorbing layer, thereby improving the optoelectronic performance and stability of perovskite solar cells.

In some embodiments, L includes one or more of substituted or unsubstituted alkylene, substituted or unsubstituted cycloalkylene, and substituted or unsubstituted arylene.

The alkylene refers to a hydrocarbon group with two monovalent group centers, which is derived by removing one hydrogen atom from an alkyl group. It may be a saturated branched alkyl or a saturated straight-chain alkyl. For example, "C₁-C₉ alkylene" means the alkyl portion containing 1-9 carbon atoms, and each time it appears, it may independently be C₁ alkylene, C₄ alkylene, C₅ alkylene, C₆ alkylene, C₇ alkylene, C₈ alkylene, or C₉ alkylene. Suitable examples include, but are not limited to: methylene (-CH₂-), 1,1-ethylene (-CH(CH₃)-), 1,2-ethylene (-CH₂CH₂-), 1,1-propylene (-CH(CH₂CH₃)-), 1,2-propylene (-CH₂CH(CH₃)-), 1,3-propylene (-CH₂CH₂CH₂-), and 1,4-butylene (-CH₂CH₂CH₂CH₂-).

The cycloalkylene refers to a non-aromatic hydrocarbon group containing ring carbon atoms with two monovalent group centers, which is derived by removing one hydrogen atom from a cycloalkyl group. It may be monocycloalkylene, spirocycloalkylene, or bridged cycloalkylene. Phrases including this term, such as "C₃-C₉ cycloalkylene," mean cycloalkylene containing 3-9 carbon atoms, and each time it appears, it may independently be cyclopropylene, cyclobutylene, cyclopentylene, cyclohexylene, cycloheptylene, cyclooctylene, or cyclononylene. In addition, the cycloalkylene may also contain one or more double bonds, and representative examples of the cycloalkylene containing double bonds include cyclopentenylene, cyclohexenylene, cyclohexadienylene, and cyclobutadienylene.

The arylene refers to an aromatic hydrocarbon group derived by removing two hydrogen atoms from an aromatic ring compound, and may be monocyclic arylene, fused ring arylene, or polycyclic arylene. For polycyclic rings, at least one is an aromatic ring system. For example, "C₆-C₂₀ arylene" means arylene containing 6-20 carbon atoms, and each time it appears, it may independently be C₆ arylene, C₁₀ arylene, C₁₄ arylene, C₁₈ arylene, or C₂₀ arylene.

In a possible embodiment, the phosphorus-containing passivator has a structure represented by formula (II) below: 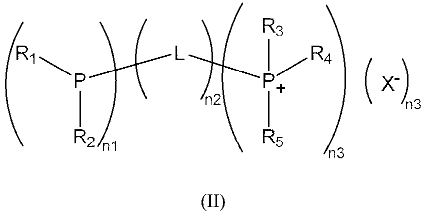
where R₁, R₂, R₃, R₄, and R₅ each include any one of substituted or unsubstituted alkyl, substituted or unsubstituted cycloalkyl, and substituted or unsubstituted aryl;
L includes any one of substituted or unsubstituted alkylene, substituted or unsubstituted cycloalkylene, and substituted or unsubstituted arylene;
X includes any one of halide anions and halogen-containing anionic groups; and
1 ≤ n1 ≤ 4, 1 ≤ n2 ≤ 10, 1 ≤ n3 ≤ 4, and n1, n2, n3 are integers.

It should be noted that R₁, R₂, R₃, R₄, and R₅ each include any one of substituted or unsubstituted alkyl, substituted or unsubstituted cycloalkyl, and substituted or unsubstituted aryl. n1, n2, and n3 each are integers.

The alkyl refers to a saturated hydrocarbon containing primary (normal) carbon atoms, secondary carbon atoms, tertiary carbon atoms, quaternary carbon atoms, or combinations thereof. Phrases including this term, such as "C₁-C₉ alkyl," mean alkyl containing 1-9 carbon atoms, and each time it appears, it may independently be C₁ alkyl, C₂ alkyl, C₃ alkyl, C₄ alkyl, C₅ alkyl, C₆ alkyl, C₇ alkyl, C₈ alkyl, or C₉ alkyl.

The cycloalkyl refers to a non-aromatic hydrocarbon containing cyclic carbon atoms, and may be monocyclic cycloalkyl, spirocycloalkyl, or bridged cycloalkyl. Phrases including this term, such as "C₃-C₉ cycloalkyl," mean cycloalkyl containing 3-9 carbon atoms, and each time it appears, it may independently be C₃ cycloalkyl, C₄ cycloalkyl, C₅ cycloalkyl, C₆ cycloalkyl, C₇ cycloalkyl, C₈ cycloalkyl, or C₉ cycloalkyl. Suitable examples include, but are not limited to, cyclopropyl, cyclobutyl, cyclopentyl, cyclohexyl, and cycloheptyl. In addition, the "cycloalkyl" may also contain one or more double bonds, and representative examples of the cycloalkyl containing double bonds include cyclopentenyl, cyclohexenyl, cyclohexadienyl, and cyclobutadienyl.

The aryl refers to an aromatic hydrocarbon group derived by removing one hydrogen atom from an aromatic ring compound, and may be monocyclic aryl, fused ring aryl, or polycyclic aryl. For polycyclic rings, at least one is an aromatic ring system. For example, "C₆-C₂₀ aryl" means aryl containing 6-20 carbon atoms, and each time it appears, it may independently be C₆ aryl, C₁₀ aryl, C₁₄ aryl, Cis aryl, or C₂₀ aryl. Suitable examples include, but are not limited to, benzene, biphenyl, naphthalene, anthracene, phenanthrene, perylene, triphenylene, and derivatives thereof.

It should be noted that "substituted or unsubstituted" means that the defined group may be substituted or unsubstituted. When the defined group is substituted, it should be understood as optionally substituted by groups acceptable in the art, including but not limited to, alkyl, alkoxy, alkenyl, alkynyl, aryl, heteroaryl, heteroalkyl, heterocyclyl, amino, and halogen.

In some embodiments, R₁, R₂, R₃, R₄, and R₅ each include any one of alkyl having 1-10 carbon atoms, cycloalkyl having 1-10 carbon atoms, phenyl, and substituted phenyl; and substituents in the substituted phenyl include one or more of halogen, alkyl, cycloalkyl, alkoxy, alkylthio, alkylsilyl, and alkoxysilyl.

It should be noted that R₁, R₂, R₃, R₄, and R₅ each include any one of alkyl having 1-10 carbon atoms, cycloalkyl having 1-10 carbon atoms, phenyl, and substituted phenyl.

In some optional embodiments, the substituents in the substituted phenyl include one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

The alkoxy refers to a group having -O-alkyl, meaning that an alkyl group linked to the parent structure via an oxygen atom. Phrases including this term, such as "C₁-C₉ alkoxy," mean the alkyl portion containing 1-9 carbon atoms, and each time it appears, it may independently be C₁ alkoxy, C₄ alkoxy, C₅ alkoxy, C₆ alkoxy, C₇ alkoxy, C₈ alkoxy, or C₉ alkoxy. Suitable examples include, but are not limited to, methoxy (-O-CH₃ or -OMe), ethoxy (-O-CH₂CH₃ or -OEt), and tert-butoxy (-O-C(CH₃)₃ or -OtBu).

The alkylthio refers to an alkyl group in which at least one carbon atom is replaced by element sulfur, and the alkyl group is linked to the parent structure via a sulfur atom.

The alkylsilyl refers to an alkyl group in which at least one carbon atom is replaced by element silicon, and the alkyl group is linked to the parent structure via a silicon atom.

The alkoxysilyl refers to an alkyl group in which at least one carbon atom is replaced by element silicon, and the alkoxy group is linked to the parent structure via a silicon atom.

In some embodiments, R₁ and R₂ each include any one of cycloalkyl having 1-10 carbon atoms and phenyl.

It should be noted that R₁ and R₂ each include any one of cycloalkyl having 1-10 carbon atoms and phenyl.

In some optional embodiments, R₁ and R₂ each identically include any one of cycloalkyl having 1-10 carbon atoms and phenyl.

In some embodiments, R₃, R₄, and R₅ each include any one of alkyl having 1-10 carbon atoms.

It should be noted that R₃, R₄, and R₅ each include any one of alkyl having 1-10 carbon atoms.

In some optional embodiments, R₃, R₄, and R₅ each identically include any one of alkyl having 1-10 carbon atoms.

In a possible embodiment, L includes any one of alkylene having 1-10 carbon atoms, cycloalkylene having 1-10 carbon atoms, phenylene, and substituted phenylene; and substituents in the substituted phenylene include one or more of halogen, alkyl, cycloalkyl, alkoxy, alkylthio, alkylsilyl, and alkoxysilyl.

In some optional embodiments, the substituents in the substituted phenylene include one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

In some embodiments, L includes any one of alkylene having 1-10 carbon atoms.

In some embodiments, X includes any one of iodide ions and tetrafluoroborate ions.

In some embodiments, the phosphorus-containing passivator includes any one of the following structural formulas M1 to M14:

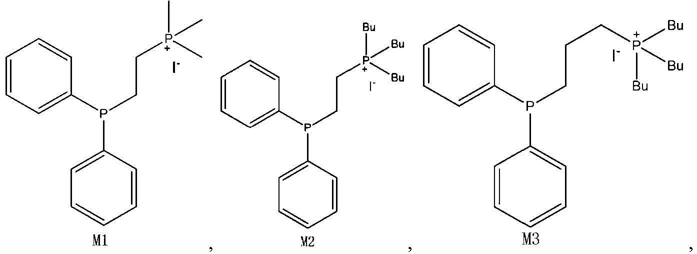

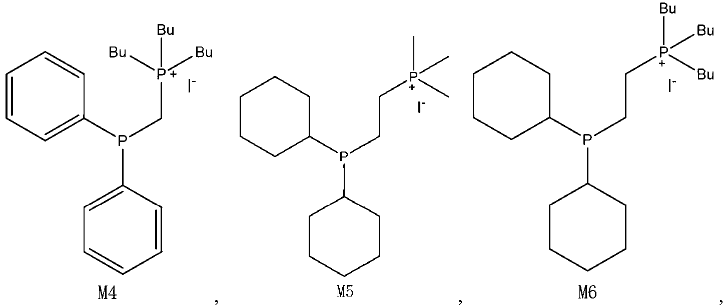

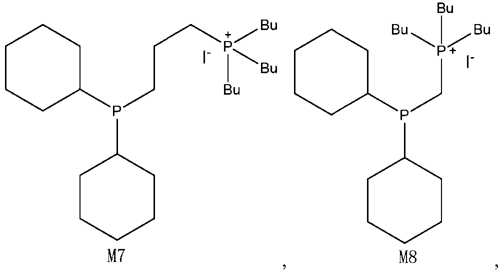

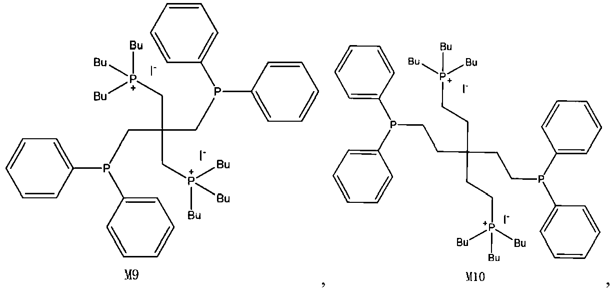

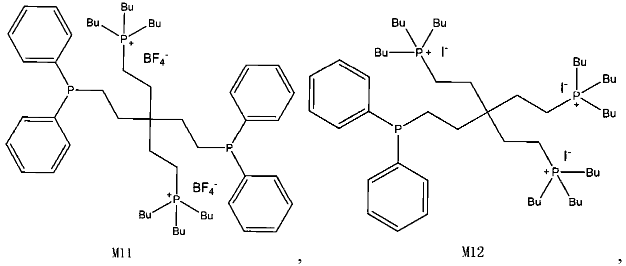

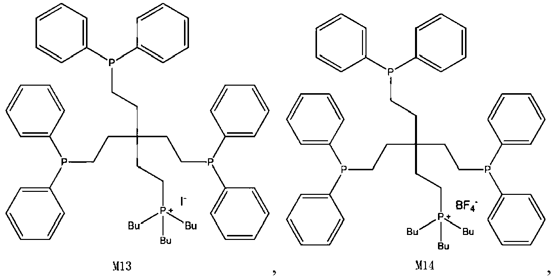

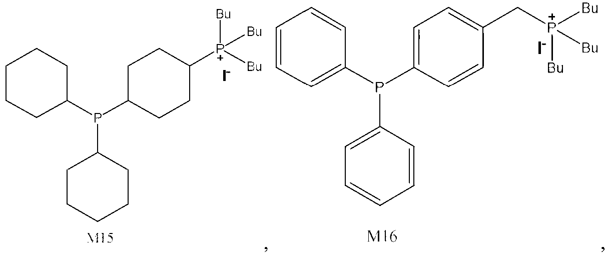

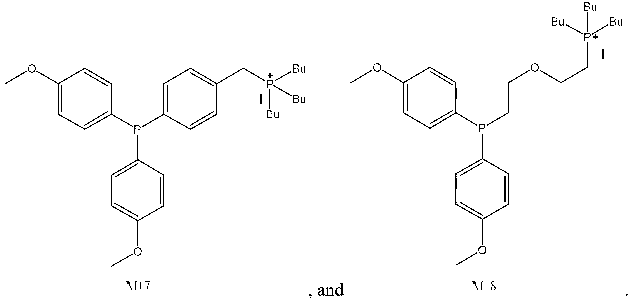

A second aspect of the present application provides a perovskite solar cell, where the perovskite solar cell includes the phosphorus-containing passivator according to the first aspect of the present application. By adding the phosphorus-containing passivator during the preparation process, a perovskite solar cell containing the phosphorus-containing passivator is obtained, where the phosphorus-containing passivator can coordinatively passivate under-coordinated lead ion defects, interface defects, and iodide ion vacancy defects, which reduces energy loss of charges in the bulk phase and/or at the interfaces of a perovskite light-absorbing layer, thereby improving the optoelectronic performance and stability of the perovskite solar cell.

In some embodiments, the perovskite solar cell includes a perovskite light-absorbing layer, where the perovskite light-absorbing layer includes the phosphorus-containing passivator, During the preparation of the perovskite light-absorbing layer, the phosphorus-containing passivator is directly added to passivate under-coordinated lead ion defects, interface defects, and iodide ion vacancy defects of the perovskite light-absorbing layer.

In some optional embodiments, a mass proportion of the phosphorus-containing passivator in the perovskite light-absorbing layer is 0.01% to 1%. In an example, the mass proportion of the phosphorus-containing passivator in the perovskite light-absorbing layer may be, but is not limited to, 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, and in a range defined by any two of the above values. With the mass proportion of the phosphorus-containing passivator in the perovskite light-absorbing layer being within the above range, under-coordinated lead ion defects, interface defects, and iodide ion vacancy defects of the perovskite light-absorbing layer can be effectively passivated. Optionally, the mass proportion of the phosphorus-containing passivator in the perovskite light-absorbing layer is 0.05% to 0.5%.

In an example, the mass proportion of the phosphorus-containing passivator in the perovskite light-absorbing layer mentioned above can be measured by the following method: obtaining powder of the perovskite light-absorbing layer and measuring percentage of element phosphorus in the light-absorbing layer using an elemental analysis method.

In some embodiments, the perovskite solar cell includes a perovskite light-absorbing layer and a passivation layer that are arranged in a stacked manner, where the passivation layer is located on a light-incident side or a light-exit side of the perovskite light-absorbing layer, and the passivation layer includes the phosphorus-containing passivator. Forming a passivation layer on an upper surface or a lower surface of the perovskite light-absorbing layer can passivate under-coordinated lead ion defects, interface defects, and iodide ion vacancy defects of the perovskite light-absorbing layer.

It should be noted that the light-incident side is a side where sunlight enters the perovskite light-absorbing layer; and the light-exit side is a side where sunlight exits the perovskite light-absorbing layer.

In some optional embodiments, a thickness of the passivation layer is 0.1 nanometers to 10 nanometers (nm). In an example, the thickness of the passivation layer may be, but is not limited to, 0.1 nm, 0.5 nm, 1 nm, 2 nm, 3 nm, 4 nm, 5 nm, 6 nm, 7 nm, 8 nm, 9 nm, 10 nm, or in a range defined by any two of the above values. With the thickness of the passivation layer being within the above range, under-coordinated lead ion defects, interface defects, and iodide ion vacancy defects of the perovskite light-absorbing layer can be effectively passivated. Optionally, the thickness of the passivation layer is 1 nm to 10 nm.

In an example, the thickness of the passivation layer mentioned above can be measured using instruments such as an ellipsometer or an atomic force microscope.

In some embodiments, the perovskite light-absorbing layer includes an active material with a molecular formula of ABX₃ or A₂CDX₆.

Optionally, A includes one or more of organic cations and inorganic cations; and further optionally, A includes one or more of monovalent formamidinium cations, monovalent ammonium cations, and Cs⁺.

Optionally, B includes one or more of organic cations and inorganic cations; and further optionally, B includes one or more of Pb²⁺ and Sn²⁺.

Optionally, C includes one or more of organic cations and inorganic cations; and further optionally, C includes Ag⁺.

Optionally, D includes one or more of organic cations and inorganic cations; and further optionally, D includes one or more of Bi³⁺, Sb³⁺, and In³⁺.

Optionally, X includes one or more of organic anions and inorganic anions; and further optionally, X includes one or more of Br⁻ and I⁻.

In some embodiments, a thickness of the perovskite light-absorbing layer is 100 nm to 1000 nm. In an example, the thickness of the perovskite light-absorbing layer may be, but is not limited to, 100 nm, 200 nm, 300 nm, 400 nm, 500 nm, 600 nm, 700 nm, 800 nm, 900 nm, 1000 nm, or in a range defined by any two of the above values. With the thickness of the perovskite light-absorbing layer being within the above range, sunlight can be effectively absorbed, achieving optimal photoelectric conversion efficiency and stability.

In an example, the thickness of the perovskite light-absorbing layer mentioned above can be measured using instruments such as an ellipsometer or an atomic force microscope.

In some embodiments, a bandgap width of the perovskite light-absorbing layer is 1.2 electron volts to 2.3 electron volts (eV). In an example, the bandgap width of the perovskite light-absorbing layer may be, but is not limited to, 1.2 eV, 1.3 eV, 1.4 eV, 1.5 eV, 1.6 eV, 1.7 eV, 1.8 eV, 1.9 eV, 2 eV, 2.1 eV, 2.2 eV, 2.3 eV, or in a range defined by any two of the above values. With the bandgap width of the perovskite light-absorbing layer being within the above range, high visible light absorption efficiency can be achieved.

In an example, the bandgap width of the perovskite light-absorbing layer mentioned above can be measured by the following method: measuring an absorption spectrum of the perovskite light-absorbing layer using an ultraviolet-visible spectrophotometer, measuring an emission spectrum of the perovskite light-absorbing layer using a photoluminescence spectrometer, and calculating the bandgap width of the perovskite light-absorbing layer from the intersections of the absorption spectrum and the emission spectrum.

In some embodiments, the perovskite solar cell further includes a transparent conductive substrate, an electron transport layer, a hole transport layer, and an electrode layer; where the transparent conductive substrate, the electron transport layer, the perovskite light-absorbing layer, the hole transport layer, and the electrode layer are sequentially arranged in a stacked manner to form a regular device structure, and the perovskite light-absorbing layer includes the phosphorus-containing passivator.

In some embodiments, the perovskite solar cell further includes a transparent conductive substrate, an electron transport layer, a hole transport layer, and an electrode layer; where the transparent conductive substrate, the hole transport layer, the perovskite light-absorbing layer, the electron transport layer, and the electrode layer are sequentially arranged in a stacked manner to form an inverted device structure, and the perovskite light-absorbing layer includes the phosphorus-containing passivator.

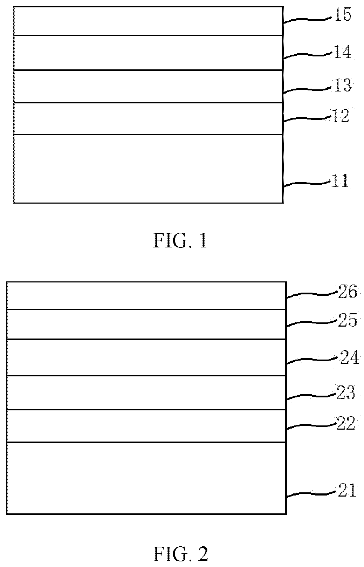

FIG. 1 is a schematic diagram of a structure of a perovskite solar cell, where 11 represents a transparent conductive substrate, 12 represents an electron transport layer or a hole transport layer, 13 represents a perovskite light-absorbing layer, 14 represents a hole transport layer or an electron transport layer, and 15 represents an electrode layer. When 12 represents an electron transport layer and 14 represents a hole transport layer, the transparent conductive substrate, the electron transport layer, the perovskite light-absorbing layer, the hole transport layer, and the electrode layer are sequentially arranged in a stacked manner to form a regular device structure, where the perovskite light-absorbing layer contains the phosphorus-containing passivator. When 12 represents a hole transport layer and 14 represents an electron transport layer, the transparent conductive substrate, the hole transport layer, the perovskite light-absorbing layer, the electron transport layer, and the electrode layer are sequentially arranged in a stacked manner to form an inverted device structure, where the perovskite light-absorbing layer contains the phosphorus-containing passivator.

In some embodiments, the perovskite solar cell further includes a transparent conductive substrate, an electron transport layer, a hole transport layer, and an electrode layer; where the transparent conductive substrate, the electron transport layer, the passivation layer, the perovskite light-absorbing layer, the hole transport layer, and the electrode layer are sequentially arranged in a stacked manner to form a regular device structure, and the passivation layer contains the phosphorus-containing passivator.

In some embodiments, the perovskite solar cell further includes a transparent conductive substrate, an electron transport layer, a hole transport layer, and an electrode layer; where the transparent conductive substrate, the electron transport layer, the perovskite light-absorbing layer, the passivation layer, the hole transport layer, and the electrode layer are sequentially arranged in a stacked manner to form a regular device structure, the passivation layer contains the phosphorus-containing passivator.

FIG. 2 is a schematic diagram of a structure of a perovskite solar cell, where 21 represents a transparent conductive substrate, 22 represents an electron transport layer, 23 represents a passivation layer or a perovskite light-absorbing layer, 24 represents a perovskite light-absorbing layer or a passivation layer, 25 represents a hole transport layer, and 26 represents an electrode layer. When 23 represents a passivation layer and 24 represents a perovskite light-absorbing layer, the transparent conductive substrate, the electron transport layer, the passivation layer, the perovskite light-absorbing layer, the hole transport layer, and the electrode layer are sequentially arranged in a stacked manner to form a regular device structure, where the passivation layer contains the phosphorus-containing passivator. When 23 represents a perovskite light-absorbing layer and 24 represents a passivation layer, the transparent conductive substrate, the electron transport layer, the perovskite light-absorbing layer, the passivation layer, the hole transport layer, and the electrode layer are sequentially arranged in a stacked manner to form a regular device structure, where the passivation layer contains the phosphorus-containing passivator.

In some embodiments, the perovskite solar cell further includes an electron transport layer, a barrier layer, and an electrode layer that are located on a light-exit side of the perovskite light-absorbing layer, where the electron transport layer, the barrier layer, and the electrode layer are sequentially arranged in a stacked manner, and the electron transport layer is closer to the perovskite light-absorbing layer. The barrier layer can effectively block the transport of holes, reducing energy loss due to charge recombination.

In some optional embodiments, a material of the barrier layer includes one or more of 2,9-dimethyl-4,7-diphenyl-1,10-phenanthroline (BCP), SnO₂, ZnO, and cerium-containing oxides. By using the above materials to prepare the barrier layer, the barrier layer can have a lower valence band top, further enhancing the effect of the barrier layer on the transport of holes.

In some optional embodiments, a thickness of the barrier layer is 0.5 nm to 20 nm. In an example, the thickness of the barrier layer may be, but is not limited to, 0.50 nm, 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, or in a range defined by any two of the above values. With the thickness of the barrier layer being within the above range, holes can be effectively blocked without being too thick to affect electron transport.

In an example, the thickness of the barrier layer mentioned above can be measured using instruments such as an ellipsometer or an atomic force microscope.

In some embodiments, the perovskite solar cell includes a transparent conductive substrate, a hole transport layer, a passivation layer, a perovskite light-absorbing layer, an electron transport layer, a barrier layer, and an electrode layer that are sequentially arranged in a stacked manner; where the passivation layer contains the phosphorus-containing passivator.

In some embodiments, the perovskite solar cell includes a transparent conductive substrate, a hole transport layer, a perovskite light-absorbing layer, a passivation layer, an electron transport layer, a barrier layer, and an electrode layer that are sequentially arranged in a stacked manner; where the passivation layer contains the phosphorus-containing passivator.

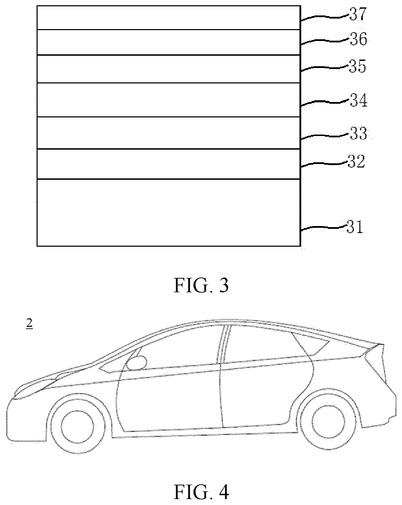

FIG. 3 is a schematic diagram of a structure of a perovskite solar cell, where 31 represents a transparent conductive substrate, 32 represents a hole transport layer, 33 represents a passivation layer or a perovskite light-absorbing layer, 34 represents a perovskite light-absorbing layer or a passivation layer, 55 represents an electron transport layer, 36 represents a barrier layer, and 37 represents an electrode layer. When 33 represents a passivation layer and 34 represents a perovskite light-absorbing layer, the transparent conductive substrate, the hole transport layer, the passivation layer, the perovskite light-absorbing layer, the electron transport layer, the barrier layer, and the electrode layer are sequentially arranged in a stacked manner to form an inverted device structure, where the passivation layer contains the phosphorus-containing passivator. When 33 represents a perovskite light-absorbing layer and 34 represents a passivation layer, the transparent conductive substrate, the hole transport layer, the perovskite light-absorbing layer, the passivation layer, the electron transport layer, the barrier layer, and the electrode layer are sequentially arranged in a stacked manner to form an inverted device structure, where the passivation layer contains the phosphorus-containing passivator.

The transparent conductive substrate is used for light incidence. In some embodiments, the transparent conductive substrate includes a substrate and a conductive material layer; where the conductive material layer is located on a side of the substrate close to the perovskite light-absorbing layer.

In some of these embodiments, a conductive material in the conductive material layer includes one or more of fluorine-doped tin dioxide (FTO), indium tin oxide (ITO), aluminum-doped zinc oxide (AZO), boron-doped zinc oxide (BZO), and indium-doped zinc oxide (IZO).

In some of these embodiments, a thickness of the transparent conductive substrate is 10 nm to 1000 nm. With the thickness of the transparent conductive substrate being within the above range, light transmission can be ensured while enhancing its conductivity. In an example, the thickness of the transparent conductive substrate may include, but is not limited to, 10 nm, 50 nm, 100 nm, 200 nm, 300 nm, 400 nm, 500 nm, 600 nm, 700 nm, 800 nm, 900 nm, 1000 nm, or in a range defined by any two of the above values.

In the present application, the substrate may be, but is not limited to, a glass substrate or a flexible substrate; materials for the flexible substrate may include, for example (but are not limited to), organic polymer materials, and further, may be mixed in different proportions from one or more of the following materials, including but not limited to, polyvinyl alcohol (PVA), polyester (PET), polyimide (PI), polyethylene naphthalate (PEN), and polydimethylsiloxane (PDMS).

The electron transport layer can extract and transport electron carriers and block free holes from passing through. In some embodiments, materials used for the electron transport layer include one or more of TiO₂, ZnO, SnO₂, [6,6]-phenyl C₆₁ butyric acid methyl ester (PC₆₁BM), [6,6]-phenyl C₇₁ butyric acid methyl ester (PC₇₁BM), fullerene C₆₀ (C₆₀), fullerene C₇₀ (C₇₀), naphthalene diimide (NDI)-based materials, perylene diimide (PDI)-based materials, and derivatives, dopants, passivates, and doped passivates of the above substances.

In some embodiments, a thickness of the electron transport layer is 5 nm to 100 nm. In an example, the thickness of the electron transport layer may include, but is not limited to, 5 nm, 10 nm, 20 nm, 30 nm, 40 nm, 50 nm, 60 nm, 70 nm, 80 nm, 90 nm, 100 nm, or in a range defined by any two of the above values. With the thickness of the electron transport layer being within the above range, the electron transport effect can be optimized.

The hole transport layer can extract and transport hole carriers and block free electrons from passing through. In some embodiments, materials used for the hole transport layer include one or more of metal oxides, polymers, small molecules, and derivatives, dopants, passivates, and doped passivates of the above substances. Optionally, the metal oxides include one or more of nickel oxide, molybdenum oxide, and tungsten oxide. Optionally, the polymers include one or more of poly(3,4-ethylenedioxythiophene):poly(styrenesulfonate) (PEDOT:PSS), poly[bis(4-phenyl)(2,4,6-trimethylphenyl)amine] (PTAA), and poly[bis(4-phenyl)(4-butylphenyl)amine] (Poly-TPD). Optionally, the small molecules include one or more of 4-(3,6-dimethylcarbazol-9-yl)butylphosphonic acid (Me-4PACZ), 2-(3,6-dimethoxycarbazol-9-yl)ethylphosphonic acid (MeO-2PACZ), and 4-(carbazol-9-yl)butylphosphonic acid (4PACZ).

In some embodiments, a thickness of the hole transport layer is 0.1 nm to 100 nm. In an example, the thickness of the hole transport layer may include, but is not limited to, 0.1 nm, 1 nm, 10 nm, 20 nm, 30 nm, 40 nm, 50 nm, 60 nm, 70 nm, 80 nm, 90 nm, 100 nm, or in a range defined by any two of the above values. With the thickness of the hole transport layer being within the above range, the hole transport effect can be optimized.

In some embodiments, a material of the electrode layer includes one or more of organic conductive materials and inorganic conductive materials; and optionally, materials used for the electrode layer include one or more of silver, copper, carbon, gold, aluminum, indium tin oxide, aluminum-doped zinc oxide, boron-doped zinc oxide, and indium-doped zinc oxide.

In some possible embodiments, a thickness of the electrode layer is 10 nm to 1000 nm, With the thickness of the electrode layer being within the above range, the charge collection effect can be optimized. In an example, the thickness of the electrode layer may include, but is not limited to, 10 nm, 50 nm, 100 nm, 200 nm, 300 nm, 400 nm, 500 nm, 600 nm, 700 nm, 800 nm, 900 nm, 1000 nm, or in a range defined by any two of the above values.

During operation of the perovskite cell, the perovskite light-absorbing layer, upon being illuminated, has its internal electrons gain energy and break free from the constraints of the perovskite light-absorbing layer, to form negatively charged electron carriers and positively charged hole carriers, thereby generating electron-hole pairs. Free electrons and free holes are transported in opposite directions through their respective transport layers, causing electrons and holes to flow and form an external current, achieving the conversion of light energy into electrical energy. Further, after absorbing photons, the perovskite light-absorbing layer is excited to produce electron-hole pairs, where the electron-hole pairs further dissociate to form free carriers with opposite charges. The free electrons are transported to the positive electrode through the electron transport layer, and the free holes are transported to the negative electrode through the hole transport layer. The two types of free carriers are collected by their respective electrodes, further forming a photocurrent in the circuit of the perovskite cell.

It can be understood that one of the transparent conductive substrate and the electrode layer serves as the positive electrode and can collect electron carriers transported via the electron transport layer, and the other serves as the negative electrode and can collect hole carriers transported via the hole transport layer.

In some embodiments, a preparation method of the perovskite solar cell includes the following steps: preparing an electron transport layer on a side of a transparent conductive substrate having a conductive material layer; preparing a perovskite light-absorbing layer on a side of the electron transport layer away from the transparent conductive substrate, where the perovskite light-absorbing layer contains the phosphorus-containing passivator; preparing a hole transport layer on a side of the perovskite light-absorbing layer away from the electron transport layer; and preparing an electrode layer on a side of the hole transport layer away from the perovskite light-absorbing layer. This method produces a regular device structure.

In some embodiments, a preparation method of the perovskite solar cell includes the following steps: preparing a hole transport layer on a side of a transparent conductive substrate having a conductive material layer; preparing a perovskite light-absorbing layer on a side of the hole transport layer away from the transparent conductive substrate, where the perovskite light-absorbing layer contains the phosphorus-containing passivator; preparing an electron transport layer on a side of the perovskite light-absorbing layer away from the hole transport layer; and preparing an electrode layer on a side of the electron transport layer away from the perovskite light-absorbing layer. This method produces an inverted device structure.

In some embodiments, a preparation method of the perovskite solar cell includes the following steps: preparing an electron transport layer on a side of a transparent conductive substrate having a conductive material layer; preparing a passivation layer on a side of the electron transport layer away from the transparent conductive substrate, where the passivation layer contains the phosphorus-containing passivator; preparing a perovskite light-absorbing layer on a side of the passivation layer away from the electron transport layer; preparing a hole transport layer on a side of the perovskite light-absorbing layer away from the passivation layer; and preparing an electrode layer on a side of the hole transport layer away from the perovskite light-absorbing layer. This method produces a regular device structure.

In some embodiments, a preparation method of the perovskite solar cell includes the following steps: preparing an electron transport layer on a side of a transparent conductive substrate having a conductive material layer; preparing a perovskite light-absorbing layer on a side of the electron transport layer away from the transparent conductive substrate; preparing a passivation layer on a side of the perovskite light-absorbing layer away from the electron transport layer, where the passivation layer contains the phosphorus-containing passivator; preparing a hole transport layer on a side of the passivation layer away from the perovskite light-absorbing layer; and preparing an electrode layer on a side of the hole transport layer away from the passivation layer. This method produces a regular device structure.

In some embodiments, a preparation method of the perovskite solar cell includes the following steps: preparing a hole transport layer on a side of a transparent conductive substrate having a conductive material layer; preparing a passivation layer on a side of the hole transport layer away from the transparent conductive substrate, where the passivation layer contains the phosphorus-containing passivator; preparing a perovskite light-absorbing layer on a side of the passivation layer away from the hole transport layer; preparing an electron transport layer on a side of the perovskite light-absorbing layer away from the passivation layer; preparing a barrier layer on a side of the electron transport layer away from the perovskite light-absorbing layer; and preparing an electrode layer on a side of the barrier layer away from the electron transport layer. This method produces an inverted device structure.

In some embodiments, a preparation method of the perovskite solar cell includes the following steps: preparing a hole transport layer on a side of a transparent conductive substrate having a conductive material layer; preparing a perovskite light-absorbing layer on a side of the hole transport layer away from the transparent conductive substrate; preparing a passivation layer on a side of the perovskite light-absorbing layer away from the hole transport layer, where the passivation layer contains the phosphorus-containing passivator; preparing an electron transport layer on a side of the passivation layer away from the perovskite light-absorbing layer; preparing a barrier layer on a side of the electron transport layer away from the perovskite light-absorbing layer; and preparing an electrode layer on a side of the barrier layer away from the electron transport layer. This method produces an inverted device structure.

In some of these embodiments, the passivation layer may be prepared using one of spin coating, spray coating, blade coating, slot-die coating, and roll-to-roll printing.

In some of these embodiments, the process of preparing the passivation layer includes preparing a passivation layer slurry, where a solvent used for preparing the passivation layer slurry includes one or more of water, methanol, ethanol, isopropanol, N,N-dimethylformamide, dimethyl sulfoxide, chloroform, chlorobenzene, and toluene, and a concentration of the phosphorus-containing passivator in the passivation layer slurry is 0.001 mg/mL to 10 mg/mL; for example, the concentration of the phosphorus-containing passivator in the passivation layer slurry may be, but is not limited to, 0.001 mg/mL, 0.01 mg/mL, 0.1 mg/mL, 1 mg/mL, 2 mg/mL, 3 mg/mL, 4 mg/mL, 5 mg/mL, 6 mg/mL, 7 mg/mL, 8 mg/mL, 9 mg/mL, 10 mg/mL, or in a range defined by any two of the above values.

It can be understood that the structure of the perovskite cell according to the present application may not be limited to the structural layers listed above. Other functional layers, such as buffer layers, may also be introduced as needed. In some embodiments, the perovskite cell may include a buffer layer with suitable energy levels, which can serve one or more functions, such as reducing energy level barriers, promoting energy level matching, improving carrier extraction efficiency, passivating interface defect states, protecting the light-absorbing layer, suppressing oxidative decomposition of the cell by water molecules and oxygen, improving photoelectric conversion efficiency, and enhancing the stability of the perovskite cell. Depending on the position of the buffer layer, the types of buffer layers may include a buffer layer between the hole transport layer and the anode, a buffer layer between the electron transport layer and the cathode, a buffer layer between the hole transport layer and the light-absorbing layer, and a buffer layer between the electron transport layer and the light-absorbing layer. Materials that can be used for buffer layers in perovskite cells may include, but are not limited to, Cu₂O, NiO, AZO, and TiO₂.

A third aspect of the present application provides a photovoltaic module including the perovskite solar cell according to the second aspect of the present application.

The perovskite solar cell described above has high photoelectric conversion efficiency and good stability, which can improve the photoelectric efficiency and stability of the photovoltaic module.

The perovskite solar cell is provided in one or more, which can be selected based on specific application scenario. Further, the above photovoltaic module includes multiple perovskite solar cells, where the multiple perovskite solar cells are connected in series or parallel to form a solar cell string.

In some of these embodiments, the photovoltaic module further includes a photovoltaic glass layer, an adhesive layer, and a backsheet.

Two surfaces of the solar cell string are both provided with an adhesive layer, with a backsheet disposed on a surface of one adhesive layer away from the solar cell string, and a photovoltaic glass layer disposed on a surface of the other adhesive layer away from the solar cell string.

The photovoltaic glass layer and the backsheet are configured to protect the perovskite solar cell, providing sealing, insulation, and waterproof functions; and the adhesive layer serves to bond the photovoltaic glass layer to the solar cell string and the backsheet to the solar cell string.

Optionally, a material of the photovoltaic glass layer is tempered glass, a material of the backsheet is TPT (polyvinyl fluoride) or TPE (thermoplastic elastomer), and a material of the adhesive layer is EVA (ethylene-vinyl acetate copolymer).

Further, the photovoltaic module further includes a junction box and a frame.

The junction box is configured to protect the power generation system of the entire photovoltaic module, acting as a current transfer station; and under a condition that a solar cell string is short-circuited, the junction box automatically disconnects the shorted cell string.

The frame can support and protect the entire photovoltaic module, and the frame may be made of aluminum alloy, with excellent strength and corrosion resistance.

Further, silicone is used to bond and seal the connections between the frame and other parts of the photovoltaic module. The photovoltaic module can convert solar energy into electrical energy, store the solar energy in a battery, or drive a load.

In some of these embodiments, the photovoltaic module is a solar panel.

A fourth aspect of the present application provides a photovoltaic system including the photovoltaic module according to the third aspect of the present application.

The photovoltaic system utilizes the perovskite solar cell in the photovoltaic module to directly convert solar radiation energy into electrical energy, with high efficiency and good stability; and further, the photovoltaic system is a photovoltaic power generation system.

The photovoltaic module is the core component of the photovoltaic power generation system. The photovoltaic system includes one or more photovoltaic modules, which can be selected based on specific application scenarios; and further, when the photovoltaic system includes multiple photovoltaic modules, the multiple photovoltaic modules form a photovoltaic array.

The photovoltaic system may be an off-grid photovoltaic power generation system or a grid-connected photovoltaic power generation system.

The off-grid photovoltaic power generation system includes a photovoltaic array, a battery bank, a charge controller, a power electronic converter (inverter), a load, and the like. The working principle of the off-grid photovoltaic power generation system is that solar radiation energy is first converted into electrical energy by the photovoltaic array, then transformed by the power electronic converter to supply the load, while excess electrical energy is stored in an energy storage apparatus in the form of chemical energy through the charge controller. In this way, under the condition that sunlight is insufficient, the energy stored in the battery can be converted into 220 V, 50 Hz alternating current power through the power electronic inverter, a filter, and a power frequency transformer for use by alternating current loads.

The grid-connected photovoltaic power generation system includes a photovoltaic array, a high-frequency DC/DC boost circuit, a power electronic converter (inverter), and system monitoring. The working principle of the grid-connected photovoltaic power generation system is that solar radiation energy is converted by the photovoltaic array, then transformed into high-voltage DC through high-frequency direct current conversion, and then inverted by the power electronic inverter to output sinusoidal alternating current synchronized with the grid voltage frequency to the grid.

The two types of photovoltaic power generation systems each have their characteristics and can be selected based on specific application scenarios.

A fifth aspect of the present application provides an electric apparatus including the perovskite solar cell according to the second aspect of the present application.

In some of these embodiments, the perovskite solar cell can be used as a power generation apparatus for the electric apparatus. The type of power generation apparatus may include, but is not limited to, integrated power generation. The position of the power generation apparatus may include, but is not limited to, locations such as the roof or back panel of a vehicle.

Further, the electric apparatus may include mobile devices such as mobile phones, laptops, electric vehicles, electric trains, ships, satellites, and power generation systems, but is not limited thereto.

FIG. 4 shows an electric apparatus as an example. The electric apparatus is a vehicle, which may further be a battery electric vehicle, a hybrid electric vehicle, or a plug-in hybrid electric vehicle, or the like.

In another example, the electric apparatus may be a mobile phone, tablet, laptop, calculator, or the like.

In another example, the electric apparatus may be a wearable device, such as a watch, or the like.

The following further describes the beneficial effects of the present application with reference to examples.

To make the technical problems solved by the present application, the technical solutions, and the beneficial effects clearer, further detailed descriptions are provided below in conjunction with the embodiments and the accompanying drawings. Apparently, the described embodiments are merely some but not all of the embodiments of the present application. The following description of at least one exemplary embodiment is merely illustrative and definitely is not construed as any limitation on the present application or on the use of the present application. Based on the embodiments in the present application, all other embodiments obtained by those of ordinary skill in the art without creative efforts fall within the scope of protection of the present application. The materials used in the examples and comparative examples of the present application can all be obtained commercially.

For techniques or conditions not specified in the embodiments, they are performed according to the techniques or conditions described in the literature in the field or according to product specifications. The reagents or instruments used are all conventional products that can be commercially available if no manufacturer is indicated.

### I. Preparation of phosphorus-containing passivator

### 1. Preparation of phosphorus-containing passivator M1

Process 1: 1.86 g of compound 1 and 10 mL of tetrahydrofuran were added into a three-neck flask 1. After compound 1 dissolved, the temperature was lowered to -78°C, and 4 mL of a 2.5 M solution of n-butyllithium (n-BuLi) in n-hexane was added dropwise to the three-neck flask 1, followed by stirring for 2 hours for later use. In a three-neck flask 2, 2.81 g of compound 2 and 10 mL of tetrahydrofuran were added. After compound 2 dissolved, the solution from the three-neck flask 1 was added dropwise to the three-neck flask 2, followed by stirring for 12 hours. After the reaction, the product was processed by silica gel column chromatography to obtain 2.79 g of compound 3 with a yield of 80%. ¹H NMR (400 MHz, CD₂Cl₂) was measured as *δ* 7.42 (d, *J* = 7.2 Hz, 6H), 7.15 (d, *J* = 7.2 Hz, 4H), 3.03-2.98 (m, 2H), and 2.01-1.96 (m, 2H). The reaction process is as follows:

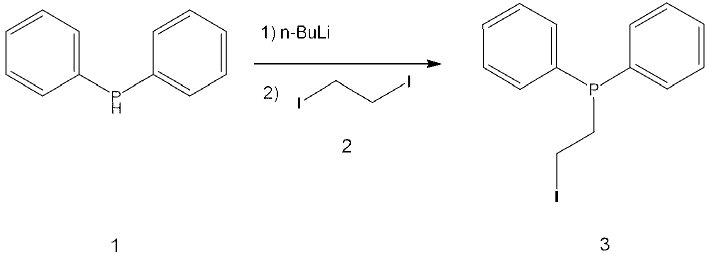

Process 2: 340 mg of compound 3, 76 mg of trimethylphosphine (P(CH₃)₃), and 10 mL of o-dichlorobenzene (o-DCB) were added into a three-neck flask 3 and heated at 160°C for 12 hours. After the reaction, the precipitated solid was dissolved in 10 mL of water, and the aqueous phase was washed three times with 10 mL of dichloromethane. Finally, water was removed by reduced-pressure distillation to obtain 408 mg of phosphorus-containing passivator M1 with a yield of 98%. ¹H NMR (400 MHz, D₂O) was measured as *δ* 7.42 (d, *J* = 7.2 Hz, 6H), 7.15 (d, *J* = 7.2 Hz, 4H), 2.54-2.50 (m, 2H), 1.50-1.46 (m, 2H), and 0.89 (s, 9H). The reaction process is as follows:

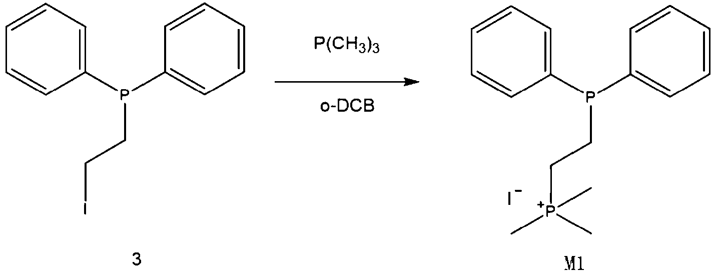

### 2. Preparation of phosphorus-containing passivator M2

The preparation of phosphorus-containing passivator M2 differs from that of phosphorus-containing passivator M1 in that: in Process 2, 76 mg of trimethylphosphine (P(CH₃)₃) was replaced with 202 mg of tributylphosphine (PBu₃). After reaction and post-processing steps, 526 mg of phosphorus-containing passivator M2 was obtained with a yield of 97%. ¹H NMR (400 MHz, D₂O) was measured as *δ* 7.42 (d, *J* = 7.2 Hz, 6H), 7.15 (d, *J =* 7.2 Hz, 4H), 2.54-2.48 (m, 8H), 1.50-1.38 (m, 14H), and 0.90 (s, 9H). The reaction process is as follows:

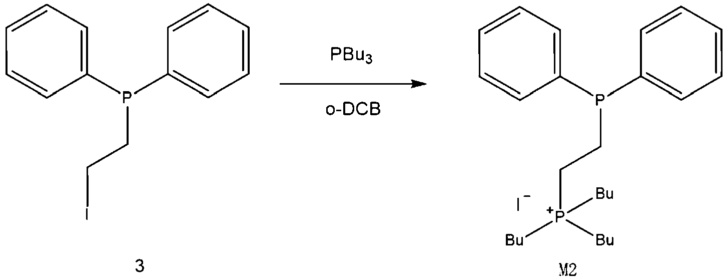

### 3. Preparation of phosphorus-containing passivator M3

The preparation of phosphorus-containing passivator M3 differs from that of phosphorus-containing passivator M1 in that:
(1) In Process 1, 2.81 g of compound 2 was replaced with 2.96 g of compound 4. After the reaction, 2.83 g of compound 5 was obtained with a yield of 80%. ¹H NMR (400 MHz, CD₂Cl₂) was measured as *δ* 7.42 (d, *J = 7.2* Hz, 6H), 7.15 (d, *J = 7.2* Hz, 4H), 2.94-2.88 (m, 2H), 1.91-1.86 (m, 2H), and 1.45-1.39 (m, 2H). The reaction process is as follows: 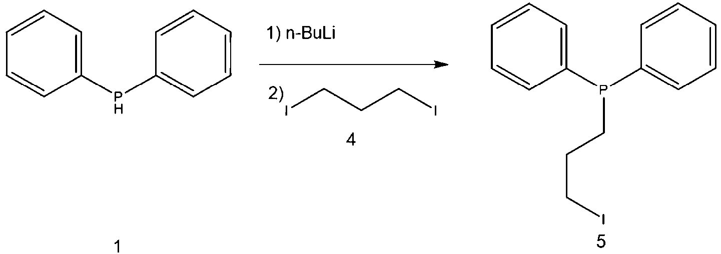
(2) In Process 2, 340 mg of compound 3 was replaced with 354 mg of compound 5, and 76 mg of trimethylphosphine (P(CH₃)₃) was replaced with 202 mg of tributylphosphine. After reaction and post-processing steps, 536 mg of phosphorus-containing passivator M3 was obtained with a yield of 99%. ¹H NMR (400 MHz, D₂O) was measured as *δ* 7.42 (d, *J* = 7.2 Hz, 6H), 7.15 (d, *J* = 7.2 Hz, 4H), 2.54-2.50 (m, 8H), 1.50-1.36 (m, 16H), and 0.89 (s, 9H). The reaction process is as follows:

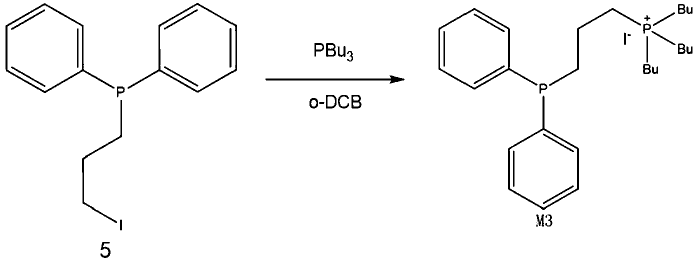

### 4. Preparation of Phosphorus-containing passivator M4

The preparation of phosphorus-containing passivator M4 differs from that of phosphorus-containing passivator M1 in that:
(1) In Process 1, 2.81 g of compound 2 was replaced with 2.67 g of compound 6. After the reaction, 2.36 g of compound 7 was obtained with a yield of 72%. ¹H NMR (400 MHz, CD₂Cl₂) was measured as *δ* 7.42 (d, *J =* 7.2 Hz, 6H), 7.15 (d, *J = 7.2* Hz, 4H), and 2.96 (d, *J* = 7.2 Hz, 2H). The reaction process is as follows: 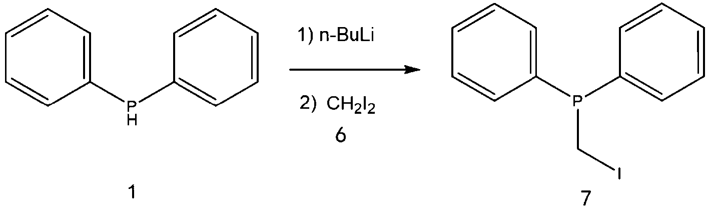
(2) In Process 2, 340 mg of compound 3 was replaced with 326 mg of compound 7, and 76 mg of trimethylphosphine (P(CH₃)₃) was replaced with 202 mg of tributylphosphine. After reaction and post-processing steps, 524 mg of phosphorus-containing passivator M4 was obtained with a yield of 99%. ¹H NMR (400 MHz, D₂O) was measured as *δ* 7.42 (d, *J =* 7.2 Hz, 6H), 7.15 (d, *J* = 7.2 Hz, 4H), 2.55-2.51 (m, 8H), 1.51-1.34 (m, 12H), and 0.91 (s, 9H). The reaction process is as follows:

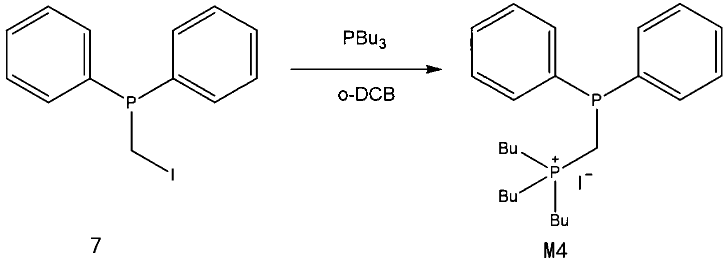

### 5. Preparation of phosphorus-containing passivator M5

The preparation of phosphorus-containing passivator M5 differs from that of phosphorus-containing passivator M1 in that:
(1) In Process 1, 1.86 g of compound 1 was replaced with 1.98 g of compound 8. After the reaction, 2.82 g of compound 9 was obtained with a yield of 79%. ¹H NMR (400 MHz, CD₂Cl₂) was measured as *δ* 3.03-2.98 (m, 2H), 2.07-1.95 (m, 2H), and 1.62-1.29 (m, 22H). The reaction process is as follows: 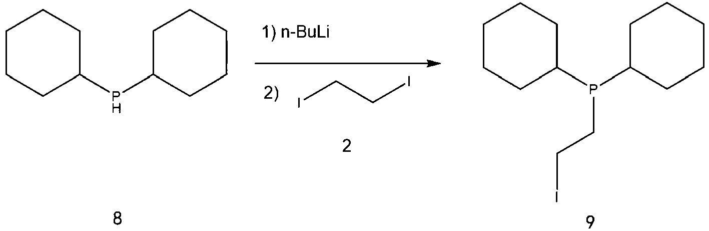
(2) In Process 2, 340 mg of compound 3 was replaced with 352 mg of compound 9. After reaction and post-processing steps, 423 mg of phosphorus-containing passivator M5 was obtained with a yield of 99%. ¹H NMR (400 MHz, D₂O) was measured as *δ* 2.58-2.48 (m, 2H), 1.62-1.29 (m, 24H), and 0.90 (s, 9H). The reaction process is as follows:

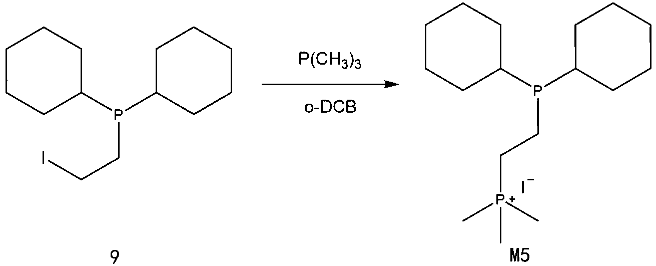

### 6. Preparation of phosphorus-containing passivator M6

The preparation of phosphorus-containing passivator M6 differs from that of phosphorus-containing passivator M5 in that:
In Process 2, 76 mg of trimethylphosphine was replaced with 202 mg of tributylphosphine. After reaction and post-processing steps, 423 mg of phosphorus-containing passivator M6 was obtained with a yield of 99%. ¹H NMR (400 MHz, D₂O) was measured as *δ* 2.58-2.48 (m, 8H), 1.62-1.29 (m, 30H), and 0.89 (s, 9H). The reaction process is as follows:

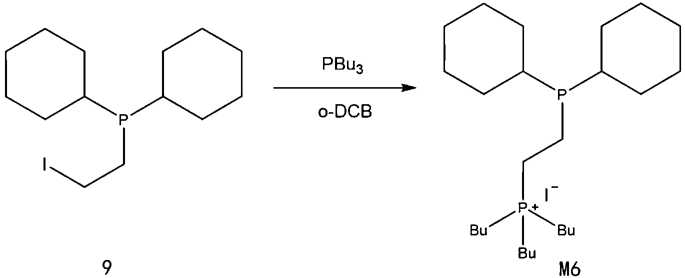

### 7. Preparation of phosphorus-containing passivator M7

The preparation of phosphorus-containing passivator M7 differs from that of phosphorus-containing passivator M5 in that:
(1) In Process 1, 2.81 g of compound 2 was replaced with 2.96 g of compound 4. After the reaction, 2.82 g of compound 10 was obtained with a yield of 79%. ¹H NMR (400 MHz, CD₂Cl₂) was measured as *δ* 3.03-2.98 (m, 2H), 2.07-1.95 (m, 2H), and 1.62-1.29 (m, 26H). The reaction process is as follows: 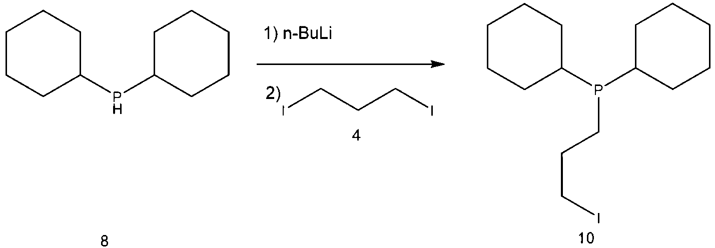
(2) In Process 2, 352 mg of compound 9 was replaced with 366 mg of compound 10. After reaction and post-processing steps, 551 mg of phosphorus-containing passivator M7 was obtained with a yield of 99%. ¹H NMR (400 MHz, D₂O) was measured as *δ* 2.58-2.48 (m, 2H), 1.64-1.27 (m, 32H), and 0.90 (s, 9H). The reaction process is as follows:

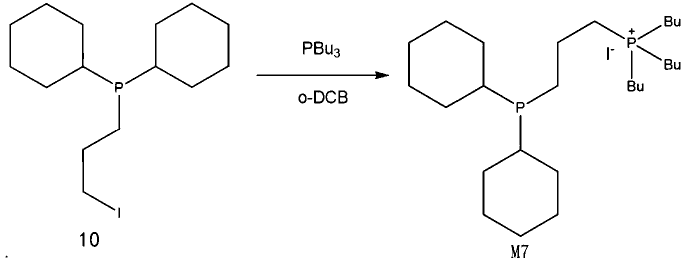

### 8. Preparation of phosphorus-containing passivator M8

The preparation of phosphorus-containing passivator M8 differs from that of phosphorus-containing passivator M5 in that:
(1) In Process 1, 2.81 g of compound 2 was replaced with 2.67 g of compound 6. After the reaction, 2.88 g of compound 11 was obtained with a yield of 78%. ¹H NMR (400 MHz, CD₂Cl₂) was measured as *δ* 3.09-2.98 (m, 2H), and 1.62-1.29 (m, 22H). The reaction process is as follows: 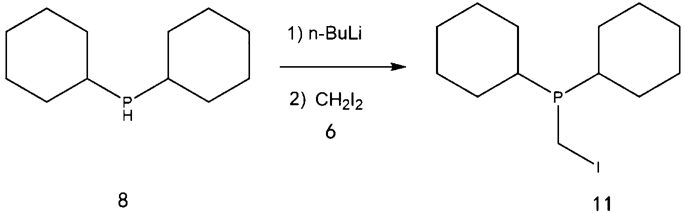
(2) In Process 2, 352 mg of compound 9 was replaced with 352 mg of compound 11. After reaction and post-processing steps, 423 mg of phosphorus-containing passivator M8 was obtained with a yield of 99%. ¹H NMR (400 MHz, D₂O) was measured as *δ* 2.58-2.48 (m, 6H), 1.62-1.29 (m, 28H), and 0.90 (s, 9H). The reaction process is as follows:

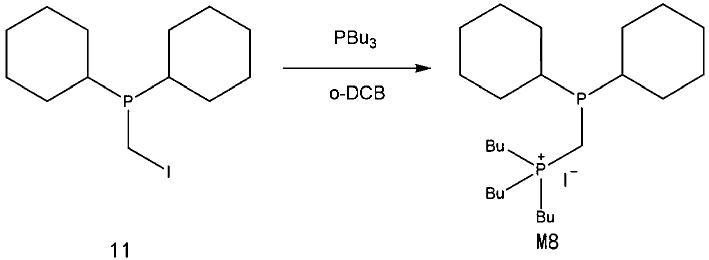

### 9. Preparation of phosphorus-containing passivator M9

The preparation of phosphorus-containing passivator M9 differs from that of phosphorus-containing passivator M1 in that:
(1) In Process 1, 2.81 g of compound 2 was replaced with 2.88 g of compound 12. After the reaction, 1.25 g of compound 13 was obtained with a yield of 37%. ¹H NMR (400 MHz, CD₂Cl₂) was measured as *δ* 7.42 (d, *J* = 7.2 Hz, 12H), 7.15 (d, *J* = 7.2 Hz, 8H), 2.79 (s, 4H), and 1.30 (d, *J* = 7.2 Hz, 4H). The reaction process is as follows: 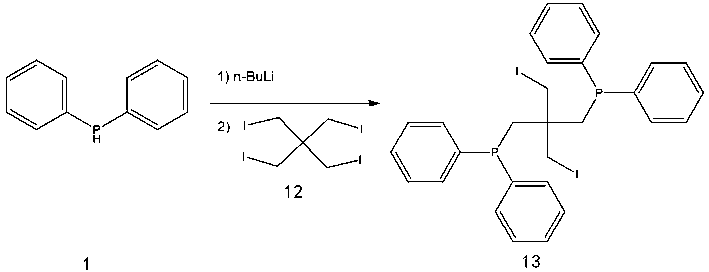
(2) In Process 2, 340 mg of compound 3 was replaced with 346 mg of compound 13, and 76 mg of trimethylphosphine (P(CH₃)₃) was replaced with 202 mg of tributylphosphine. After reaction and post-processing steps, 541 mg of phosphorus-containing passivator M9 was obtained with a yield of 99%. ¹H NMR (400 MHz, D₂O) was measured as *δ* 7.42 (d, *J* = 7.2 Hz, 12H), 7.15 (d, *J =* 7.2 Hz, 8H), 2.55-2.51 (m, 16H), 1.51-1.34 (m, 24H), and 0.91 (s, 18H). The reaction process is as follows:

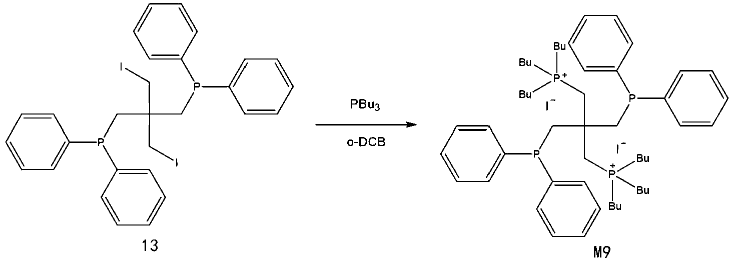

### 10. Preparation of phosphorus-containing passivator M10

The preparation of phosphorus-containing passivator M10 differs from that of phosphorus-containing passivator M1 in that:
(1) In Process 1, 2.81 g of compound 2 was replaced with 3.16 g of compound 14. After the reaction, 1.27 g of compound 15 was obtained with a yield of 34%. ¹H NMR (400 MHz, CD₂Cl₂) was measured as *δ* 7.42 (d, *J* = 7.2 Hz, 12H), 7.15 (d, *J* = 7.2 Hz, 8H), 2.95-2.87 (m, 4H), 1.47-1.38 (m, 4H), and 1.24-1.17 (m, 4H). The reaction process is as follows: 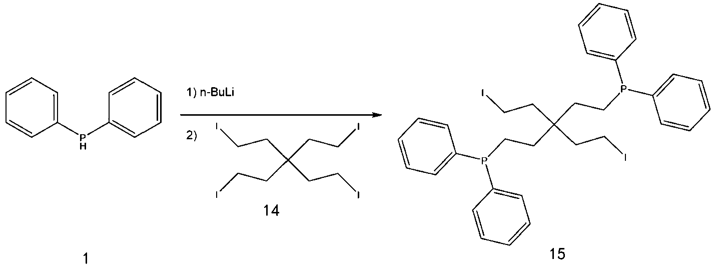
(2) In Process 2, 340 mg of compound 3 was replaced with 374 mg of compound 15, and 76 mg of trimethylphosphine (P(CH₃)₃) was replaced with 202 mg of tributylphosphine. After reaction and post-processing steps, 446 mg of phosphorus-containing passivator M10 was obtained with a yield of 99%. ¹H NMR (400 MHz, D₂O) was measured as *δ* 7.42 (d, *J* = 7.2 Hz, 12H), 7.15 (d, *J =* 7.2 Hz, 8H), 2.50-2.42 (m, 16H), 1.41-1.14 (m, 40H), and 0.90 (s, 18H). The reaction process is as follows:

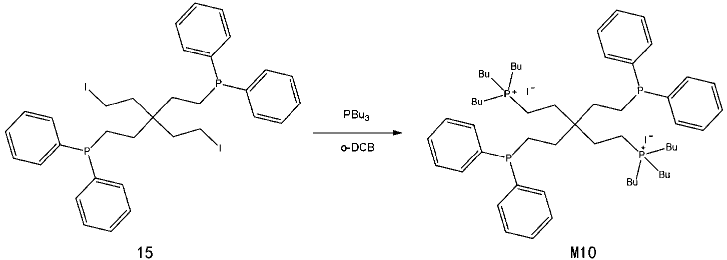

### 11. Preparation of phosphorus-containing passivator M11

100 mg of phosphorus-containing passivator M10 was passed through an ion exchange resin to obtain 98 mg of phosphorus-containing passivator M11 with a yield of 98%. ¹H NMR (400 MHz, D₂O) was measured as *δ* 7.42 (d, *J* = 7.2 Hz, 12H), 7.15 (d, *J* = 7.2 Hz, 8H), 2.50-2.42 (m, 16H), 1.41-1.14 (m, 40H), and 0.90 (s, 18H). The reaction process is as follows:

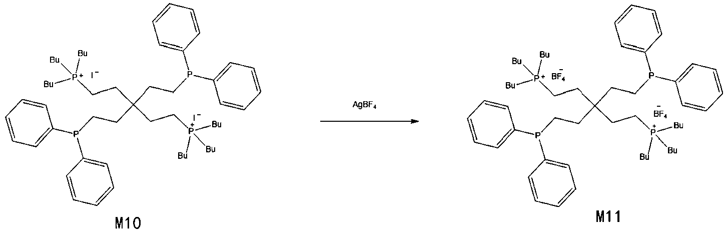

### 12. Preparation of phosphorus-containing passivator M12

The preparation of phosphorus-containing passivator M12 differs from that of phosphorus-containing passivator M10 in that:
(1) In Process 1, 3.16 g of compound 14 was replaced with 6.31 g. After the reaction, 1.27 g of compound 16 was obtained with a yield of 34%. ¹H NMR (400 MHz, CD₂Cl₂) was measured as *δ* 7.42 (d, *J* = 7.2 Hz, 6H), 7.15 (d, *J* = 7.2 Hz, 4H), 2.95-2.87 (m, 6H), 1.47-1.38 (m, 2H), and 1.24-1.17 (m, 8H). The reaction process is as follows: 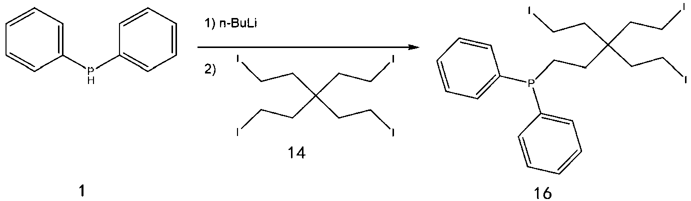
(2) In Process 2, 374 mg of compound 15 was replaced with 229 mg of compound 16. After reaction and post-processing steps, 415 mg of phosphorus-containing passivator M12 was obtained with a yield of 99%. ¹H NMR (400 MHz, D₂O) was measured as *δ* 7.42 (d, *J* = 7.2 Hz, 6H), 7.15 (d, *J* = 7.2 Hz, 4H), 2.50-2.42 (m, 6H), 1.41-1.14 (m, 64H), and 0.90 (s, 27H). The reaction process is as follows:

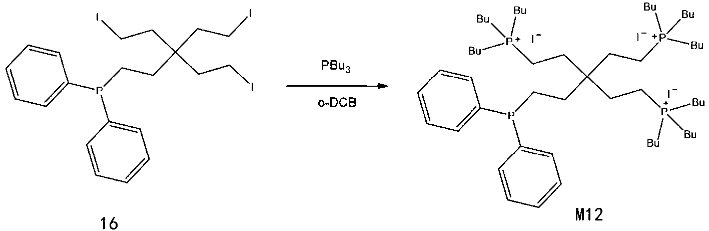

### 13. Preparation of phosphorus-containing passivator M13

The preparation of phosphorus-containing passivator M13 differs from that of phosphorus-containing passivator M10 in that:
(1) In Process 1, 3.16 g of compound 14 was replaced with 2.11 g. After the reaction, 1.51 g of compound 17 was obtained with a yield of 56%. ¹H NMR (400 MHz, CD₂Cl₂) was measured as *δ* 7.42 (d, *J* = 7.2 Hz, 18H), 7.15 (d, *J* = 7.2 Hz, 12H), 2.95-2.87 (m, 2H), 1.47-1.38 (m, 6H), and 1.24-1.17 (m, 8H). The reaction process is as follows: 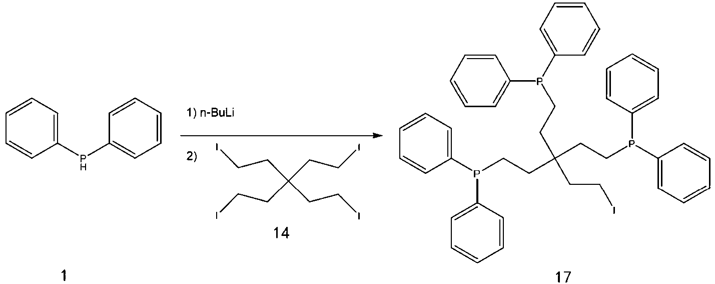
(2) In Process 2, 374 mg of compound 15 was replaced with 806 mg of compound 17. After reaction and post-processing steps, 998 mg of phosphorus-containing passivator M13 was obtained with a yield of 98%. The ¹H NMR (400 MHz, D₂O) was measured as *δ* 7.42 (d, *J = 7.2* Hz, 18H), 7.15 (d, *J = 7.2* Hz, 12H), 2.50-2.42 (m, 14H), 1.41-1.14 (m, 32H), and 0.90 (s, 9H). The reaction process is as follows:

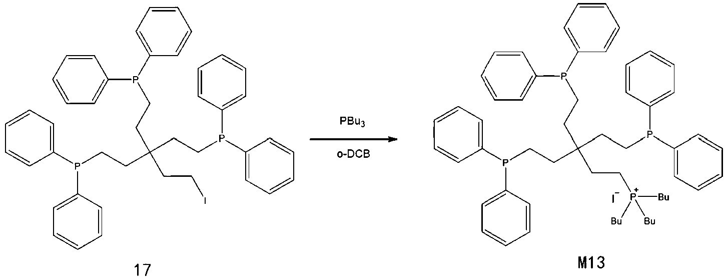

### 14. Preparation of phosphorus-containing passivator M 14

100 mg of phosphorus-containing passivator M13 was passed through an ion exchange resin to obtain 98 mg of phosphorus-containing passivator M14 with a yield of 98%. ¹H NMR (400 MHz, D₂O) was measured as *δ* 7.42 (d, *J* = 7.2 Hz, 12H), 7.15 (d, *J* = 7.2 Hz, 8H), 2.50-2.42 (m, 16H), 1.41-1.14 (m, 40H), and 0.90 (s, 18H). The reaction process is as follows:

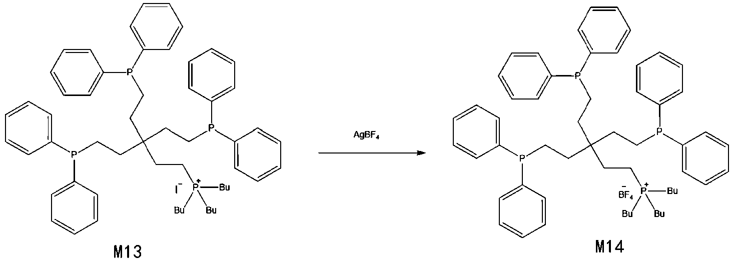

### 15. Preparation of phosphorus-containing passivator M15

The preparation of phosphorus-containing passivator M15 differs from that of phosphorus-containing passivator M1 in that:
(1) In Process 1, 2.81 g of compound 2 was replaced with 3.36 g of compound 18. After the reaction, 1.26 g of compound 19 was obtained with a yield of 32%. ¹H NMR (400 MHz, CD₂Cl₂) was measured as *δ* 7.44-7.40 (m, 6H), 7.17-7.13 (m, 4H), 4.02-3.98 (m, 2H), 2.11-2.07 (m, 4H), and 1.67-1.32 (m, 5H). The reaction process is as follows: 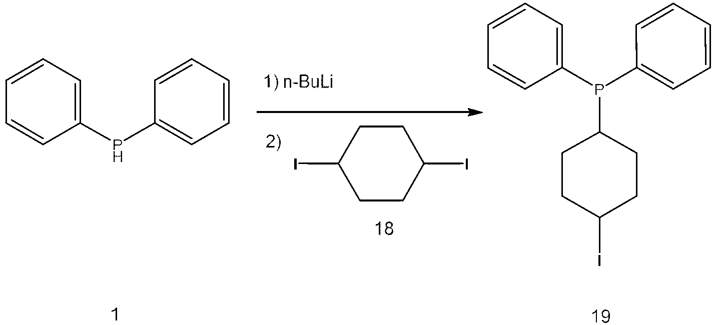
(2) In Process 2, 340 mg of compound 3 was replaced with 394 mg of compound 19, and 76 mg of trimethylphosphine (P(CH₃)₃) was replaced with 202 mg of tributylphosphine. After reaction and post-processing steps, 587 mg of phosphorus-containing passivator M15 was obtained with a yield of 98%. ¹H NMR (400 MHz, D₂O) was measured as *δ* 7.44-7.40 (m, 6H), 7.17-7.13 (m, 4H), 2.48-2.44 (m, 6H), 1.63-1.56 (m, 4H), 1.45-1.41 (m, 2H), 1.32-1.26 (m, 16H), and 0.91-0.87 (m, 9H). The reaction process is as follows:

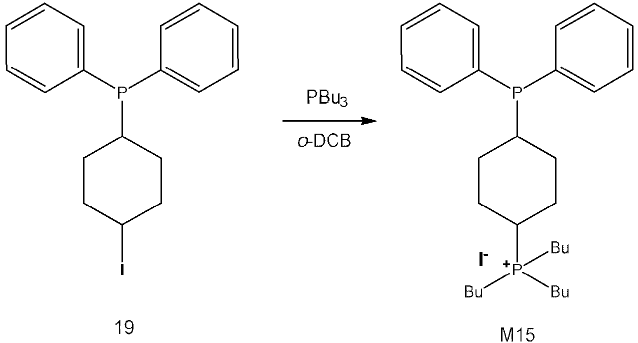

### 16. Preparation of phosphorus-containing passivator M16

The preparation of phosphorus-containing passivator M16 differs from that of phosphorus-containing passivator M1 in that:
The reaction process of Process 1 was not required. In Process 2, 340 mg of compound 3 was replaced with 394 mg of compound 20, and 76 mg of trimethylphosphine (P(CH₃)₃) was replaced with 202 mg of tributylphosphine. After reaction and post-processing steps, 601 mg of phosphorus-containing passivator M16 was obtained with a yield of 99%. ¹H NMR (400 MHz, D₂O) was measured as *δ* 7.47-7.42 (m, 6H), 7.19-7.13 (m, 8H), 2.64 (s, 2H), 1.42-1.36 (m, 18H), and 0.93-0.89 (m, 9H). The reaction process is as follows:

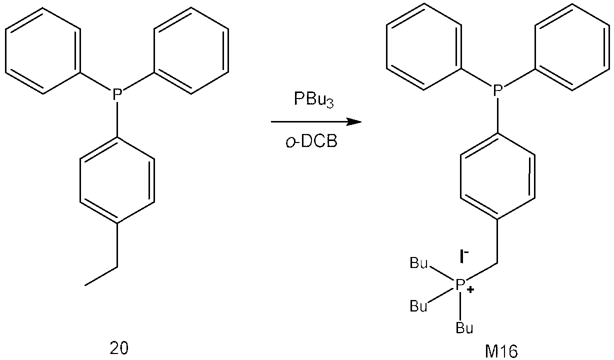

### 17. preparation of phosphorus-containing passivator M17

The preparation of phosphorus-containing passivator M17 differs from that of phosphorus-containing passivator M1 in that:
The reaction process of Process 1 was not required. In Process 2, 340 mg of compound 3 was replaced with 462 mg of compound 21, and 76 mg of trimethylphosphine (P(CH₃)₃) was replaced with 202 mg of tributylphosphine. After reaction and post-processing steps, 632 mg of phosphorus-containing passivator M17 was obtained with a yield of 95%. ¹H NMR (400 MHz, D₂O) was measured as *δ* 7.19-7.13 (m, 8H), 7.00-6.96 (m, 4H), 3.81 (s, 6H), 2.64 (s, 2H), 1.42-1.36 (m, 18H), and 0.93-0.89 (m, 9H). The reaction process is as follows:

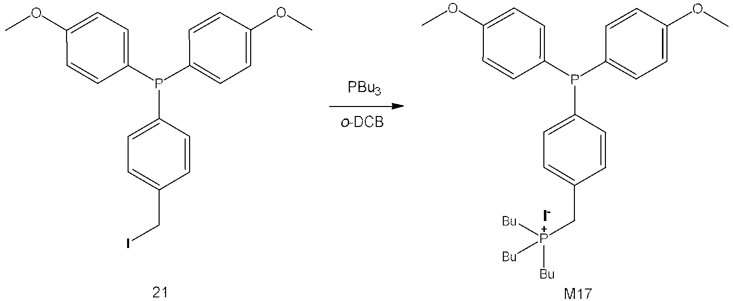

### 18. Preparation of phosphorus-containing passivator M18

The preparation of phosphorus-containing passivator M18 differs from that of phosphorus-containing passivator M1 in that:
(1) In Process 1, 2.81 g of compound 2 was replaced with 3.33 g of compound 22. After the reaction, 1.57 g of compound 23 was obtained with a yield of 41%. ¹H NMR (400 MHz, CD₂Cl₂) was measured as *δ* 7.44-7.40 (m, 6H), 7.17-7.13 (m, 4H), 3.96-3.92 (m, 4H), 3.13-3.08 (m, 2H), and 1.63-1.60 (m, 2H). The reaction process is as follows: 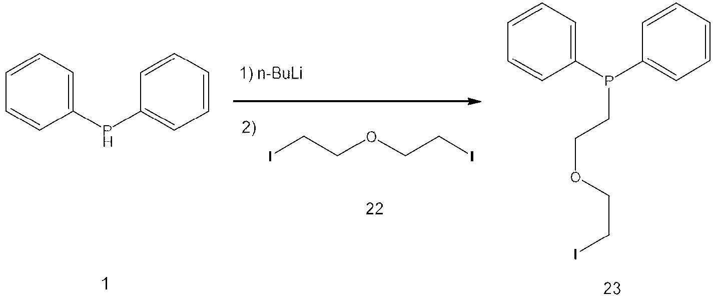
(2) In Process 2, 340 mg of compound 3 was replaced with 384 mg of compound 23, and 76 mg of trimethylphosphine (P(CH₃)₃) was replaced with 202 mg of tributylphosphine. After reaction and post-processing steps, 582 mg of phosphorus-containing passivator M18 was obtained with a yield of 99%. ¹H NMR (400 MHz, D₂O) was measured as *δ* 7.44-7.40 (m, 6H), 7.17-7.13 (m, 4H), 3.43-3.39 (m, 4H), 1.63-1.56 (m, 4H), 1.45-1.36 (m, 18H), and 0.91-0.87 (m, 9H). The reaction process is as follows:

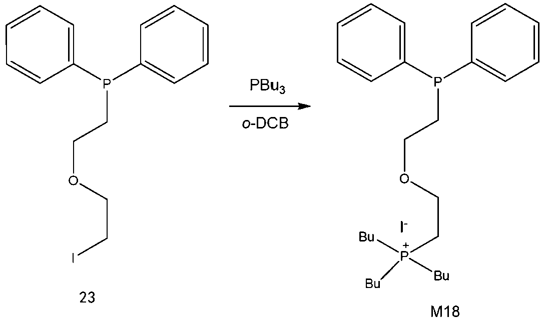

### II. Preparation of perovskite solar cell

### Example 1

(1) Twenty pieces of FTO conductive glass with dimensions of 2.0 cm × 2.0 cm were taken, and 0.35 cm of FTO was removed from two ends by laser etching to expose the glass substrate. The etched FTO conductive glass was ultrasonically cleaned several times with water, acetone, and isopropanol sequentially. The FTO conductive glass was dried under a nitrogen gun and further cleaned in an ultraviolet ozone machine; where FTO conductive glass is glass obtained by forming a conductive material layer on one side of a glass substrate using fluorine-doped tin dioxide as the conductive material.
(2) On the FTO substrate treated with ultraviolet ozone, a 10 mg/mL nickel oxide nanoparticle solution (with water as the solvent) was spin-coated at 4000 rpm, followed by annealing on a 100°C hot plate for 30 minutes to prepare a hole transport layer with a thickness of 35 nm.
(3) Lead iodide, formamidinium iodide, cesium iodide, and lead bromide were weighed in a molar ratio of 97:3:95:5, along with 1wt% of phosphorus-containing passivator M1 relative to the total weight of the four substances. The solid powders were dissolved in a mixed solution of DMF and DMSO with a volume ratio of 100: 1, stirred for 3 hours, and filtered through a 0.22 µm organic filter membrane to obtain a perovskite precursor solution. The perovskite precursor solution was spin-coated on the hole transport layer at 3000 rpm, annealed at 100°C for 30 minutes, and cooled to room temperature to obtain a perovskite light-absorbing layer with a thickness of 500 nm.
(4) A chlorobenzene solution of PC₆₁BM was spin-coated on the perovskite light-absorbing layer at 1500 rpm, followed by annealing at 100°C for 10 minutes to prepare an electron transport layer with a thickness of approximately 30 nm. Then, a BCP isopropanol solution was spin-coated at 5000 rpm to prepare a barrier layer with a thickness of 5 nm.
(5) The obtained sample was placed in a vacuum evaporator, and a metal electrode Cu was deposited to prepare an electrode layer with a thickness of approximately 100 nm.

### Examples 2 to 18 and 21 to 24

The preparation methods of the perovskite solar cells in Examples 2 to 18 and 21 to 24 were substantially similar to that of the perovskite solar cell in Example 1, with the main differences being one or more of the following: the type and/or amount of phosphorus-containing passivator, the type of barrier layer material, the thickness of the barrier layer, the type of perovskite light-absorbing layer material, the thickness of the perovskite light-absorbing layer, the type of transparent conductive substrate, the type and/or thickness of the electron transport layer, the type and/or thickness of the hole transport layer, and the type and/or thickness of the electrode layer. Specific details are provided in Table 1.

It can be understood that when the types and/or amounts of raw materials used in preparing the perovskite light-absorbing layer differ, the resulting perovskite light-absorbing layer materials differ, and the types and amounts of raw materials added during the preparation of the perovskite light-absorbing layer can be inferred from the type of the resulting perovskite light-absorbing layer. Therefore, for clarity and conciseness, Table 1 below lists only the material types of the perovskite light-absorbing layers prepared in the examples and comparative examples.

### Example 19

The preparation method of the perovskite solar cell in Example 19 differs from that of the perovskite solar cell in Example 1 mainly in that: the phosphorus-containing passivator M1 was not added to the perovskite light-absorbing layer. After preparing the perovskite light-absorbing layer, a 0.5 mg/mL isopropanol solution containing the phosphorus-containing passivator M1 was spin-coated on the surface of the perovskite light-absorbing layer at 3000 rpm to prepare a passivation layer with a thickness of 5 nm.

### Example 20

The preparation method of the perovskite solar cell in Example 20 differs from that of the perovskite solar cell in Example 1 mainly in that: the phosphorus-containing passivator M1 was not added to the perovskite light-absorbing layer. After preparing the hole transport layer, a 0.5 mg/mL isopropanol solution containing the phosphorus-containing passivator M1 was spin-coated on the surface of the hole transport layer at 3000 rpm to prepare a passivation layer with a thickness of 5 nm.

### Examples 25 and 26

The preparation methods of the perovskite solar cells in Examples 25 and 26 differ from that of the perovskite solar cell in Example 19 mainly in that: the thicknesses of the passivation layers varied, with specific details provided in Table 1.

### Comparative Example 1

Comparative Example 1 differs from Example 21 in that: no phosphorus-containing passivator was added, with all other conditions being the same. Specific details are provided in Table 1.

### Comparative Example 2

Comparative Example 2 differs from Example 21 in that: a passivator X with the following structure was used instead of the phosphorus-containing passivator M1, with all other conditions being the same. Specific details are provided in Table 1.

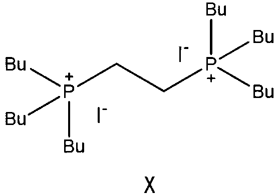

### Comparative Example 3

Comparative Example 3 differs from Example 1 in that: a passivator Y with the following structure was used instead of the phosphorus-containing passivator M1, with all other conditions being the same. Specific details are provided in Table 1.

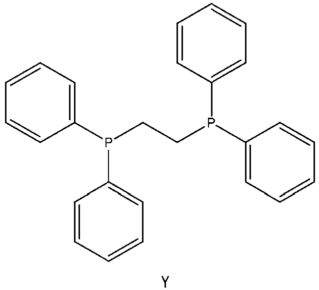

The parameter tests for the above examples and comparative examples are shown in Table 1.

**Table 1**

| Group | Perovskite light-absorbing layer | | | | Passivation layer | | Barrier layer | | Transparent conductive substrate | Hole transport layer | | Electron transport layer | | Electrode layer | |
|---|---|---|---|---|---|---|---|---|---|---|---|---|---|---|---|
| | Perovskite material | Passivator type | n1 | Thickness (nm) | Passivator type | Thickness (nm) | Materia l type | Thickness (nm) | Type | Type | Thickness (nm) | Type | Thickness (nm) | Type | Thickness (nm) |
| Example 1 | FAMACs ternary perovskite | M1 | 0.1% | 500 | / | / | BCP | 5 | FTO conductive glass | Nickel oxide | 35 | PC₆₁BM | 30 | Cu | 100 |
| Example 2 | FAMACs ternary perovskite | M2 | 0.1% | 500 | / | / | BCP | 5 | FTO conductive glass | Nickel oxide | 35 | PC₆₁BM | 30 | Cu | 100 |
| Example 3 | FAMACs ternary perovskite | M3 | 0.1% | 500 | / | / | BCP | 5 | FTO conductive glass | Nickel oxide | 35 | PC₆₁BM | 30 | Cu | 100 |
| Example 4 | FAMACs ternary perovskite | M4 | 0.1% | 500 | / | / | BCP | 5 | FTO conductive glass | Nickel oxide | 35 | PC₆₁BM | 30 | Cu | 100 |
| Example 5 | FAMACs ternary perovskite | M5 | 0.1% | 500 | / | / | BCP | 5 | FTO conductive glass | Nickel oxide | 35 | PC₆₁BM | 30 | Cu | 100 |
| Example 6 | FAMACs ternary perovskite | M6 | 0.1% | 500 | / | / | BCP | 5 | FTO conductive glass | Nickel oxide | 35 | PC₆₁BM | 30 | Cu | 100 |
| Example 7 | FAMACs ternary perovskite | M7 | 0.1% | 500 | / | / | BCP | 5 | FTO conductive glass | Nickel oxide | 35 | PC₆₁BM | 30 | Cu | 100 |
| Example 8 | FAMACs ternary perovskite | M8 | 0.1% | 500 | / | / | BCP | 5 | FTO conductive glass | Nickel oxide | 35 | PC₆₁BM | 30 | Cu | 100 |
| Example 9 | FAMACs ternary perovskite | M9 | 0.1% | 500 | / | / | BCP | 5 | FTO conductive glass | Nickel oxide | 35 | PC₆₁BM | 30 | Cu | 100 |

| Perovskite material | Passivator type | n1 | Thickness (nm) | Passivator type | Thickness (nm) | Material type | Thickness (nm) | Type | Type | Thickness (nm) | Type | Thickness (nm) | Type | Thickness (nm) | |
|---|---|---|---|---|---|---|---|---|---|---|---|---|---|---|---|
| Example 10 | FAMACs ternary perovskite | M10 | 0.1% | 500 | / | / | BCP | 5 | FTO conductive glass | Nickel oxide | 35 | PC₆₁BM | 30 | Cu | 100 |
| Example 11 | FAMACs ternary perovskite | M11 | 0.1% | 500 | / | / | BCP | 5 | FTO conductive glass | Nickel oxide | 35 | PC₆₁BM | 30 | Cu | 100 |
| Example 12 | FAMACs ternary perovskite | M12 | 0.1% | 500 | / | / | BCP | 5 | FTO conductive glass | Nickel oxide | 35 | PC₆₁BM | 30 | Cu | 100 |
| Example 13 | FAMACs ternary perovskite | M13 | 0.1% | 500 | / | / | BCP | 5 | FTO conductive glass | Nickel oxide | 35 | PC₆₁BM | 30 | Cu | 100 |
| Example 14 | FAMACs ternary perovskite | M14 | 0.1% | 500 | / | / | BCP | 5 | FTO conductive glass | Nickel oxide | 35 | PC₆₁BM | 30 | Cu | 100 |
| Example 15 | FAMACs ternary perovskite | M15 | 0.1% | 500 | / | / | BCP | 5 | FTO conductive glass | Nickel oxide | 35 | PC₆₁BM | 30 | Cu | 100 |
| Example 16 | FAMACs ternary perovskite | M16 | 0.1% | 500 | / | / | BCP | 5 | FTO conductive glass | Nickel oxide | 35 | PC₆₁BM | 30 | Cu | 100 |
| Example 17 | FAMACs ternary perovskite | M17 | 0.1% | 500 | / | / | BCP | 5 | FTO conductive glass | Nickel oxide | 35 | PC₆₁BM | 30 | Cu | 100 |
| Example 18 | FAMACs ternary perovskite | M18 | 0.1% | 500 | / | / | BCP | 5 | FTO conductive glass | Nickel oxide | 35 | PC₆₁BM | 30 | Cu | 100 |
| Example 19 | FAMACs ternary perovskite | / | / | 500 | M1 (upper passivation ) | 5 | BCP | 5 | FTO conductive glass | Nickel oxide | 35 | PC₆₁BM | 30 | Cu | 100 |
| Example 20 | FAMACs ternary perovskite | / | / | 500 | M1 (lower passivation ) | 5 | BCP | 5 | FTO conductive glass | Nickel oxide | 35 | PC₆₁BM | 30 | Cu | 100 |
| Example 21 | FAMACs ternary perovskite | M1 | 0.01% | 500 | / | / | BCP | 5 | FTO conductive glass | Nickel oxide | 35 | PC₆₁BM | 30 | Cu | 100 |
| Example 22 | FAMACs ternary perovskite | M1 | 0.05% | 500 | / | / | BCP | 5 | FTO conductive glass | Nickel oxide | 35 | PC₆₁BM | 30 | Cu | 100 |
| Example 23 | FAMACs ternary perovskite | M1 | 0.5% | 500 | / | / | BCP | 5 | FTO conductive glass | Nickel oxide | 35 | PC₆₁BM | 30 | Cu | 100 |
| Example 24 | FAMACs ternary perovskite | M1 | 1% | 500 | / | / | BCP | 5 | FTO conductive glass | Nickel oxide | 35 | PC₆₁BM | 30 | Cu | 100 |
| Example 25 | FAMACs ternary perovskite | / | / | 500 | M1 (upper passivation ) | 1 | BCP | 5 | FTO conductive glass | Nickel oxide | 35 | PC₆₁BM | 30 | Cu | 100 |
| Example 26 | FAMACs ternary perovskite | / | / | 500 | M1 (upper passivation ) | 10 | BCP | 5 | FTO conductive glass | Nickel oxide | 35 | PC₆₁BM | 30 | Cu | 100 |
| Comparative Example 1 | FAMACs ternary perovskite | / | / | 500 | / | / | BCP | 5 | FTO conductive glass | Nickel oxide | 35 | PC₆₁BM | 30 | Cu | 100 |
| Comparative Example 2 | FAMACs ternary perovskite | X | 0.01% | 500 | / | / | BCP | 5 | FTO conductive glass | Nickel oxide | 35 | PC₆₁BM | 30 | Cu | 100 |
| Comparative Example 3 | FAMACs ternary perovskite | Y | 0.01% | 500 | / | / | BCP | 5 | FTO conductive glass | Nickel oxide | 35 | PC₆₁BM | 30 | Cu | 100 |

| | | | | | | | | | | | | | | | |
|---|---|---|---|---|---|---|---|---|---|---|---|---|---|---|---|
| Note: "/" indicates the absence of the structure or material. | | | | | | | | | | | | | | | |

n1 represents the mass proportion of the phosphorus-containing passivator in the perovskite light-absorbing layer, BCP represents 2,9-dimethyl-4,7-diphenyl-1,10-phenanthroline, PC₆₁BM represents [6,6]-phenyl C₆₁ butyric acid methyl ester; FTO represents fluorine-doped tin dioxide, with a fluorine doping level of 5% atomic percentage; M1 upper passivation indicates that a passivation layer is prepared on the surface of the perovskite light-absorbing layer after the preparation of the perovskite light-absorbing layer, and M2 lower passivation indicates that a passivation layer is prepared on the surface of the hole transport layer after the preparation of the hole transport layer.

It should be noted that the thicknesses of the hole transport layer, electron transport layer, perovskite light-absorbing layer, passivation layer, barrier layer, and electrode layer in the above examples and comparative examples were measured using an atomic force microscope.

### III. Performance testing of perovskite solar cell

### Photoelectric conversion efficiency testing

A solar simulator from EnliTech was used, tested in accordance with the national standard IEC61215. The light intensity was calibrated using a crystalline silicon solar cell to achieve the same sun intensity, AM 1.5. The perovskite solar cells from the above examples and comparative examples were connected to a digital source meter, and the photoelectric conversion efficiencies on the 3rd day and the 30th day under illumination were measured. The results are shown in Table 2.

**Table 2**

| Example | Passivator | Addition content of passivator in bulk phase (%) or thickness of passivator at interface (nm) | Optimal efficiency (%) | 30th day efficiency (%) | 30th day efficiency retention percentage (%) |
|---|---|---|---|---|---|
| Example 1 | M1 | 0.1% | 24.63 | 23.94 | 97.2 |
| Example 2 | M2 | 0.1% | 24.83 | 23.99 | 96.6 |
| Example 3 | M3 | 0.1% | 23.74 | 23.22 | 97.8 |
| Example 4 | M4 | 0.1% | 24.88 | 24.21 | 97.3 |
| Example 5 | M5 | 0.1% | 25.15 | 24.87 | 98.9 |
| Example 6 | M6 | 0.1% | 25.11 | 24.73 | 98.5 |
| Example 7 | M7 | 0.1% | 23.41 | 22.87 | 97.7 |
| Example 8 | M8 | 0.1% | 24.91 | 23.71 | 95.2 |
| Example 9 | M9 | 0.1% | 24.15 | 23.82 | 98.6 |
| Example 10 | M10 | 0.1% | 24.91 | 23.84 | 95.7 |
| Example 11 | M11 | 0.1% | 24.84 | 23.90 | 96.2 |
| Example 12 | M12 | 0.1% | 24.51 | 23.47 | 95.8 |
| Example 13 | M13 | 0.1% | 24.87 | 23.94 | 96.3 |
| Example 14 | M14 | 0.1% | 24.59 | 24.15 | 98.2 |
| Example 15 | M15 | 0.1% | 23.98 | 22.99 | 95.9 |
| Example 16 | M16 | 0.1% | 24.53 | 23.41 | 95.4 |
| Example 17 | M17 | 0.1% | 24.71 | 23.15 | 93.7 |
| Example 18 | M18 | 0.1% | 24.68 | 24.01 | 97.3 |
| Example 19 | M1 upper passivation | 5 nm | 24.51 | 23.87 | 97.4 |
| Example 20 | M1 lower passivation | 5 nm | 24.76 | 23.57 | 95.2 |
| Example 21 | M1 | 0.01% | 21.51 | 19.72 | 91.7 |
| Example 22 | M1 | 0.05% | 22.52 | 21.03 | 93.4 |
| Example 23 | M1 | 0.5% | 23.19 | 21.85 | 94.2 |
| Example 24 | M1 | 1% | 20.04 | 17.88 | 89.2 |
| Example 25 | M1 upper passivation | 1 nm | 21.93 | 18.85 | 86.0 |
| Example 26 | M1 upper passivation | 10 nm | 20.75 | 18.17 | 87.6 |
| Comparative Example 1 | None | None | 19.73 | 16.43 | 83.3 |
| Comparative Example 2 | X | 0.01% | 19.84 | 17.01 | 85.7 |
| Comparative Example 3 | Y | 0.01% | 19.77 | 16.94 | 85.7 |

From the comparison of the results of Examples 1 to 26 and Comparative Examples 1 to 3 in Table 2, it can be seen that adding the phosphorus-containing passivator of the present application during the preparation of perovskite solar cells can improve the photoelectric conversion efficiency and stability of the perovskite solar cells.

The differences between Example 1 and Examples 21 to 24 lie in the mass proportion of the phosphorus-containing passivator in the perovskite light-absorbing layer. From the results of Example 1 and Examples 21 to 24, it can be seen that when M1 is added to the perovskite layer at a content of approximately 0.1%, the perovskite cell device exhibits optimal efficiency and higher stability.

The differences between Example 19 and Examples 25 and 26 lie in the thickness of the passivation layer. From the results of Example 19 and Examples 25 and 26, it can be seen that when M1 is formed as a separate layer at the interface of the perovskite layer with a thickness of approximately 5 nm, the perovskite cell device exhibits optimal efficiency and higher stability.

Technical features in the foregoing embodiments may be combined in any way. For brevity of description, possible combinations of the technical features in the foregoing embodiments are not described all. However, as long as there is no contradiction among combinations of these technical features, all the combinations should be considered within a range recorded in this specification.

The foregoing embodiments only represent several implementations of the present application, and descriptions thereof are specific and detailed, but should not be construed as a limitation on the scope of the present application. It should be noted that those of ordinary skill in the art may further make several modifications and improvements without departing from the concept of the present application, and these modifications and improvements also fall within the protection scope of the present application. Therefore, the protection scope of the present application should be subject to the appended claims.

## Claims

1. A phosphorus-containing passivator, wherein the phosphorus-containing passivator comprises an ionic compound, the ionic compound comprises a cationic group; and the cationic group has a structure represented by formula (I) below:
A-L-B (I)
wherein A represents an organophosphorus group with lone pair electrons, B represents a positively charged organophosphorus salt group, and L represents a linking group between the organophosphorus group and the organophosphorus salt group.

2. The phosphorus-containing passivator according to claim 1, wherein the ionic compound further comprises an anionic group, the anionic group comprising one or more of halide anions, pseudohalide anions, tetrafluoroborate ions, hexafluorophosphate ions, and bis(methanesulfonyl)amide ions.

3. The phosphorus-containing passivator according to any one of claims 1 and 2, wherein L comprises one or more of substituted or unsubstituted alkylene, substituted or unsubstituted cycloalkylene, and substituted or unsubstituted arylene.

4. The phosphorus-containing passivator according to any one of claims 1 to 3, wherein the phosphorus-containing passivator has a structure represented by formula (II) below: 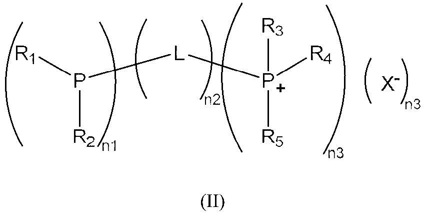
wherein R₁, R₂, R₃, R₄, and R₅ each comprise any one of substituted or unsubstituted alkyl, substituted or unsubstituted cycloalkyl, and substituted or unsubstituted aryl;
L comprises any one of substituted or unsubstituted alkylene, substituted or unsubstituted cycloalkylene, and substituted or unsubstituted arylene;
X comprises any one of halide anions and halogen-containing anionic groups; and
1 ≤ n1 ≤ 4, 1 ≤ n2 ≤ 10, 1 ≤ n3 ≤ 4, and n1, n2, n3 are integers.

5. The phosphorus-containing passivator according to claim 4, wherein R₁, R₂, R₃, R₄, and R₅ each comprise any one of alkyl having 1-10 carbon atoms, cycloalkyl having 1-10 carbon atoms, phenyl, and substituted phenyl; and substituents in the substituted phenyl comprise one or more of halogen, alkyl, cycloalkyl, alkoxy, alkylthio, alkylsilyl, and alkoxysilyl; and
optionally, the substituents in the substituted phenyl comprise one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

6. The phosphorus-containing passivator according to any one of claims 4 and 5, wherein R₁ and R₂ each comprise any one of cycloalkyl having 1-10 carbon atoms and phenyl; and
optionally, R₁ and R₂ each identically comprise any one of cycloalkyl having 1-10 carbon atoms and phenyl.

7. The phosphorus-containing passivator according to any one of claims 4 to 6, wherein R₃, R₄, and R₅ each comprise any one of alkyl having 1-10 carbon atoms; and
optionally, R₃, R₄, and R₅ each identically comprise any one of alkyl having 1-10 carbon atoms.

8. The phosphorus-containing passivator according to any one of claims 1 to 7, wherein L comprises any one of alkylene having 1-10 carbon atoms, cycloalkylene having 1-10 carbon atoms, phenylene, and substituted phenylene; and substituents in the substituted phenylene comprise one or more of halogen, alkyl, cycloalkyl, alkoxy, alkylthio, alkylsilyl, and alkoxysilyl; and
optionally, the substituents in the substituted phenylene comprise one or more of halogen, alkyl having 1-10 carbon atoms, cycloalkyl having 1-10 carbon atoms, alkoxy having 1-10 carbon atoms, alkylthio having 1-10 carbon atoms, alkylsilyl having 1-10 carbon atoms, and alkoxysilyl having 1-10 carbon atoms.

9. The phosphorus-containing passivator according to any one of claims 1 to 8, wherein L comprises any one of alkylene having 1-10 carbon atoms.

10. The phosphorus-containing passivator according to any one of claims 4 to 9, wherein X comprises any one of iodide ions and tetrafluoroborate ions.

11. The phosphorus-containing passivator according to any one of claims 1 to 10, wherein the phosphorus-containing passivator comprises any one of the following structural formulas:

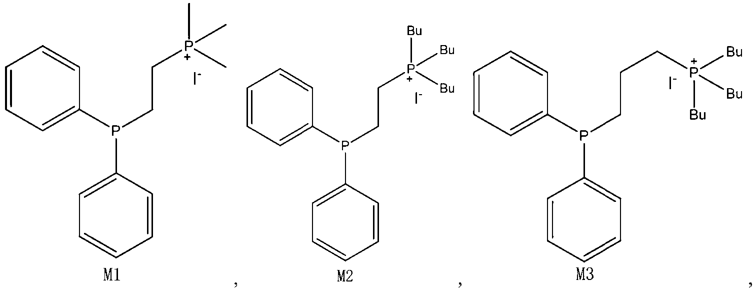

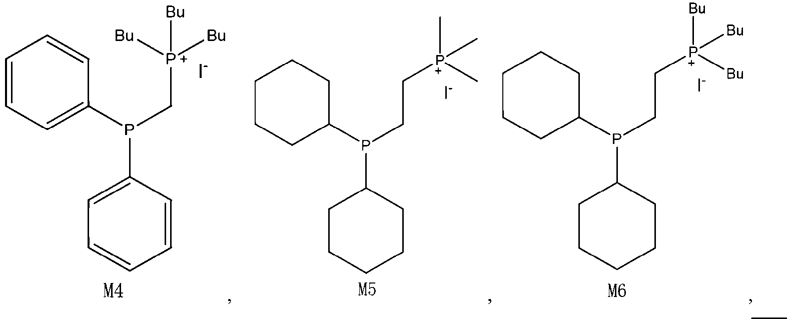

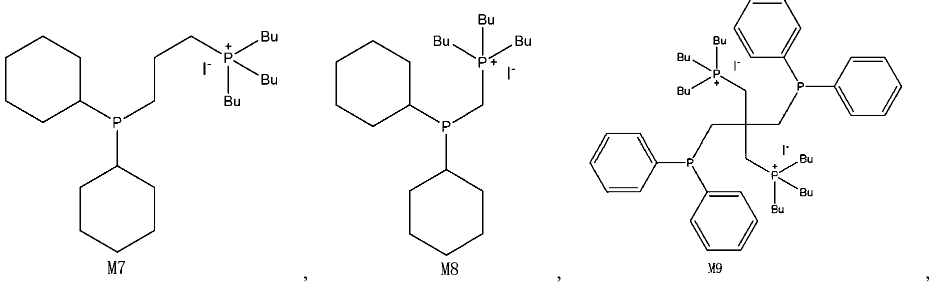

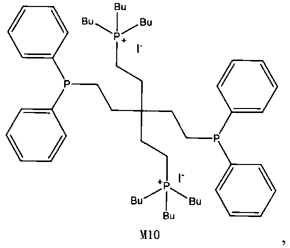

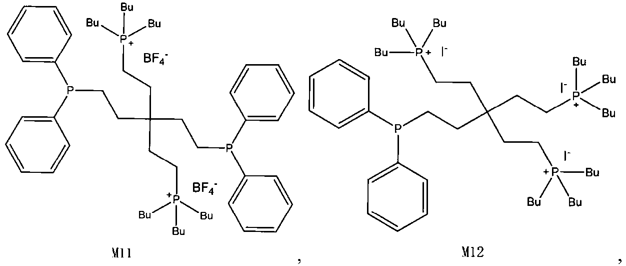

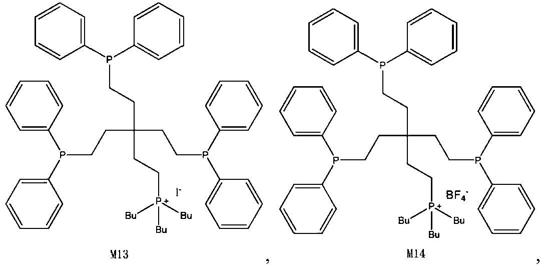

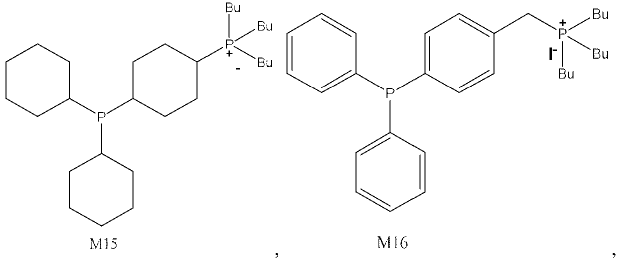

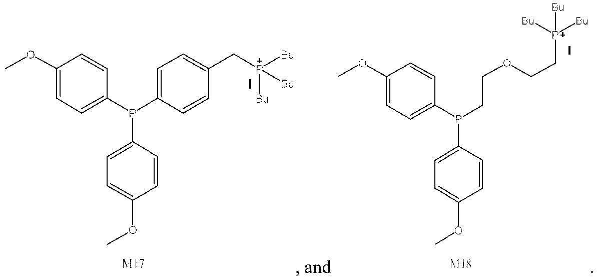

12. A perovskite solar cell, wherein the perovskite solar cell comprises the phosphorus-containing passivator according to any one of claims 1 to 11.

13. The perovskite solar cell according to claim 12, wherein the perovskite solar cell comprises a perovskite light-absorbing layer, the perovskite light-absorbing layer comprising the phosphorus-containing passivator; and
optionally, a mass proportion of the phosphorus-containing passivator in the perovskite light-absorbing layer is 0.01% to 1%; and optionally, 0.05% to 0.5%.

14. The perovskite solar cell according to claim 12, wherein the perovskite solar cell comprises a perovskite light-absorbing layer and a passivation layer that are arranged in a stacked manner, the passivation layer being located on a light-incident side or a light-exit side of the perovskite light-absorbing layer, and the passivation layer comprising the phosphorus-containing passivator; and
optionally, a thickness of the passivation layer is 0.1 nm to 10 nm; and optionally, 1 nm to 10 nm.

15. The perovskite solar cell according to any one of claims 13 and 14, wherein the perovskite light-absorbing layer comprises an active material with a molecular formula of ABX₃ or A₂CDX₆; and
optionally, the active material with the molecular formula of ABX₃ or A₂CDX₆ has at least one of the following characteristics:
(1) A comprises one or more of organic cations and inorganic cations; and optionally, A comprises one or more of monovalent formamidinium cations, monovalent ammonium cations, and Cs⁺;
(2) B comprises one or more of organic cations and inorganic cations; and optionally, B comprises one or more of Pb²⁺ and Sn²⁺;
(3) C comprises one or more of organic cations and inorganic cations; and optionally, C comprises Ag⁺;
(4) D comprises one or more of organic cations and inorganic cations; and optionally, D comprises one or more of Bi³⁺, Sb³⁺, and In³⁺; and
(5) X comprises one or more of organic anions and inorganic anions; and optionally, X comprises one or more of Br and I⁻.

16. The perovskite solar cell according to any one of claims 13 to 15, wherein the perovskite light-absorbing layer has at least one of the following characteristics:
(1) a thickness of the perovskite light-absorbing layer is 100 nm to 1000 nm; and
(2) a bandgap width of the perovskite light-absorbing layer is 1.2 eV to 2.3 eV.

17. The perovskite solar cell according to any one of claims 13 to 16, wherein the perovskite solar cell further comprises an electron transport layer, a barrier layer, and an electrode layer that are located on a light-exit side of the perovskite light-absorbing layer, the electron transport layer, the barrier layer, and the electrode layer being sequentially arranged in a stacked manner, wherein the electron transport layer is closer to the perovskite light-absorbing layer;
optionally, a material of the barrier layer comprises one or more of 2,9-dimethyl-4,7-diphenyl-1,10-phenanthroline, SnO₂, ZnO, and cerium-containing oxides; and
optionally, a thickness of the barrier layer is 0.5 nm to 20 nm.

18. A photovoltaic module comprising the perovskite solar cell according to any one of claims 12 to 17.

19. A photovoltaic system comprising the photovoltaic module according to claim 18.

20. An electric apparatus comprising the perovskite solar cell according to any one of claims 12 to 17.
